(19) Europäisches Patentamt
European Patent Office
Office européen des brevets

(11) EP 4 344 391 B1

(12) **EUROPEAN PATENT SPECIFICATION**

(45) Date of publication and mention of the grant of the patent:
**08.07.2026 Bulletin 2026/28**

(21) Application number: **23195101.3**

(22) Date of filing: **04.09.2023**

(51) International Patent Classification (IPC):
***H10K 59/38*** *(2023.01)* ***H10K 59/80*** *(2023.01)*

(52) Cooperative Patent Classification (CPC):
**H10K 59/879; H10K 59/38; H10K 59/876**

(54) **LIGHT EMITTING DEVICE, DISPLAY DEVICE, PHOTOELECTRIC CONVERSION DEVICE, AND ELECTRONIC APPARATUS**

LICHTEMITTIERENDE VORRICHTUNG, ANZEIGEVORRICHTUNG, PHOTOELEKTRISCHE UMWANDLUNGSVORRICHTUNG UND ELEKTRONISCHE VORRICHTUNG

DISPOSITIF ÉLECTROLUMINESCENT, DISPOSITIF D'AFFICHAGE, DISPOSITIF DE CONVERSION PHOTOÉLECTRIQUE ET APPAREIL ÉLECTRONIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **20.09.2022 JP 2022149540**

(43) Date of publication of application:
**27.03.2024 Bulletin 2024/13**

(73) Proprietor: **CANON KABUSHIKI KAISHA**
**Ohta-ku**
**Tokyo 146-8501 (JP)**

(72) Inventors:
- **HINATA, Shoma**
  **Tokyo (JP)**
- **ISHIHARA, Keiichiro**
  **Tokyo (JP)**
- **MATSUDA, Yojiro**
  **Tokyo (JP)**

(74) Representative: **WESER & Kollegen**
**Patentanwälte PartmbB**
**Radeckestraße 43**
**81245 München (DE)**

(56) References cited:
**EP-A1- 3 993 081** **US-A1- 2013 002 690**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 344 391 B1

## Description

BACKGROUND OF THE INVENTION

Field of the Invention

The present invention relates to a light emitting device, a display device, a photoelectric conversion device, and an electronic apparatus.

Description of the Related Art

Japanese Patent Laid-Open No. 2017-017013 describes a technique of arranging a lens on a light emitting region and adjusting the diameter of the lens and the distance between the lens and the light emitting region in order to improve light extraction efficiency in an organic light emitting display.
EP 3 993 081 A1 relates to a light-emitting device with a lens provided above a main surface of a substrate, wherein the lens has a convex curved surface portion on an opposite side to the substrate, and wherein in a first direction perpendicular to the main surface of the substrate, a light-emitting part is provided at a position more distant from the lens than a curvature center of the curved surface portion.

SUMMARY OF THE INVENTION

To improve the performance of a light emitting device, it is necessary to further efficiently extract light emitted from a light emitting region.
Some embodiments of the present invention provide a technique advantageous in improving light extraction efficiency.
The present invention in its first aspect provides a light emitting device as specified in claims 1 to 12.
The present invention in its second aspect provides a display device as specified in claim 13.
The present invention in its third aspect provides a photoelectric conversion device as specified in claim 14.
The present invention in its fourth aspect provides an electronic apparatus as specified in claim 15.
Further features of the present invention will become apparent from the following description of exemplary embodiments (with reference to the attached drawings).

BRIEF DESCRIPTION OF THE DRAWINGS

Fig. 1 is a view showing an example of the arrangement of a lens of a light emitting device according to an embodiment;
Fig. 2 is a view showing an example of the arrangement of a lens of a light emitting device according to a comparative example;
Fig. 3 is a view showing an example of the arrangement of the lens of the light emitting device according to the comparative example;
Fig. 4 is a view showing an example of the arrangement of the lens of the light emitting device according to the comparative example;
Fig. 5 is a view showing an example of the arrangement of the lens of the light emitting device according to the embodiment;
Fig. 6 is a view showing an example of the arrangement of the light emitting device according to the embodiment;
Figs. 7A to 7C are views each showing an example of the arrangement of light emitting elements of the light emitting device shown in Fig. 6;
Fig. 8 is a view showing an example of the arrangement of the light emitting device according to the embodiment;
Fig. 9 is a view showing an example of the arrangement of the light emitting device according to the embodiment;
Fig. 10 is a view showing an example of the arrangement of the light emitting device according to the embodiment;
Fig. 11 is a view showing an example of the arrangement of the light emitting device according to the embodiment;
Fig. 12 is a view showing an example of a display device using the light emitting device according to the embodiment;
Fig. 13 is a view showing an example of a photoelectric conversion device using the light emitting device according to the embodiment;
Fig. 14 is a view showing an example of an electronic apparatus using the light emitting device according to the embodiment;
Figs. 15A and 15B are views each showing an example of a display device using the light emitting device according to

the embodiment;

Fig. 16 is a view showing an example of an illumination device using the light emitting device according to the embodiment;

Fig. 17 is a view showing an example of a moving body using the light emitting device according to the embodiment; and

Figs. 18A and 18B are views each showing an example of a wearable device using the light emitting device according to the embodiment.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

A light emitting device according to an embodiment of the present disclosure will be described with reference to Figs. 1 to 11. Fig. 1 is a sectional view showing an example of the arrangement of a lens arranged in a light emitting device 10 according to this embodiment. Figs. 2 and 3 are sectional views each showing an example of a lens arranged in a light emitting device 10' according to a comparative example. The light emitting device 10 includes a substrate 8, a lens 17 with a refractive index n arranged on a main surface 34 of the substrate 8, and a light emitting region 32 arranged between the lens 17 and the main surface 34 of the substrate 8. The light emitting region 32 can be arranged in a medium layer 35 arranged between the lens 17 and the main surface 34 of the substrate 8. The shape of the lens 17 will be described in detail with reference to Figs. 1 to 3 and thus Figs. 1 to 3 do not illustrate components other than the above-described ones. The detailed arrangement of the light emitting device 10 will be described later.

The central portion of the light emitting region 32 and the central portion of the lens 17 can be arranged to overlap each other in orthogonal projection to the main surface 34 of the substrate 8. As shown in Fig. 1, the center of the light emitting region 32 and the center of the lens 17 may be arranged to overlap each other in orthogonal projection to the main surface 34 of the substrate 8. In this case, the center of the light emitting region 32 (lens 17) may be the position of the geometric centroid of the light emitting region 32 (lens 17) in orthogonal projection to the main surface 34 of the substrate 8. Furthermore, the central portion of the light emitting region 32 (lens 17) can be defined as a region inside a set of positions each of which bisects a virtual line connecting the center of the light emitting region 32 (lens 17) and the outer edge of the light emitting region 32 (lens 17).

The lens 17 can be called a microlens or the like. The upper surface of the lens 17 has a curved surface 40 that is convex in a direction away from the main surface 34 of the substrate 8. This embodiment assumes that the curved surface 40 is part of a spherical surface. The convex curved surface 40 includes a vertex 41 and an end portion 42 in a direction parallel to the main surface. The vertex 41 of the curved surface 40 is a portion, farthest from the main surface 34 of the substrate 8, of the curved surface 40 forming the upper surface of the lens 17. In the case of the arrangement shown in Fig. 1, the end portion 42 of the curved surface 40 is a portion of the lens 17, that contacts the medium layer 35. Alternatively, for example, if the outer edge portion of the lens 17 is gentle, the end portion 42 of the curved surface 40 may be a set of inflection points at which the upper surface of the lens 17 changes from the convex curved surface 40 to a concave shape. Figs. 1 to 3 each show a section, in the normal direction of the main surface 34 of the substrate 8, that passes through the vertex 41 of the curved surface 40 forming the upper surface of the lens 17.

As shown in Fig. 1, a difference in height between the vertex 41 and the end portion 42 in the normal direction of the main surface 34 of the substrate 8 is represented by h [$\mu$m] (to be sometimes referred to as a "distance h" hereinafter). A distance between the vertex 41 and the end portion 42 in orthogonal projection to the main surface 34 of the substrate 8 is represented by r [$\mu$m] (to be sometimes referred to as a "distance r" hereinafter). A difference in height between the end portion 42 and the light emitting region 32 in the normal direction of the main surface 34 of the substrate 8 is represented by H [$\mu$m] (to be sometimes referred to as a "distance H" hereinafter). The width of the light emitting region 32 in a direction parallel to the main surface 34 of the substrate 8 is $2 \times a$ [$\mu$m] (1/2 of the width of the light emitting region 32 in the direction parallel to the main surface 34 of the substrate 8 will sometimes be referred to as a "distance a" hereinafter).

In the lens 17 shown in Figs. 1 and 3, the curved surface 40 forms part of a spherical surface, and the distances h and r have a relationship of $h < r$. More specifically, the distances h and r have a relationship of $h = 0.7r$. On the other hand, in the lens 17 shown in Fig. 2, the curved surface 40 is a hemispherical surface. Therefore, the distances h and r have a relationship of $h = r$.

If no lens 17 is provided, when the shape of the light emitting region 32 is assumed to be a circular shape with a radius a (diameter 2a), an area contributing to extraction (to be sometimes referred to as "front extraction" hereinafter) of light in the normal direction of the main surface 34 of the substrate 8 is $\pi a^2$. On the other hand, in the arrangement shown in Fig. 1 in which the lens 17 is provided, the area contributing to front extraction is $\pi r^2$. The distances r and a have a

relationship r > a. Therefore, if the lens 17 is provided, the area contributing to front extraction becomes large, thereby improving light extraction efficiency.

Next, consider a path in which light emitted from the light emitting region 32 is refracted at an interface between the lens 17 with the refractive index n and air with a refractive index of 1 and is extracted. In the embodiment, assume that the refractive index of the medium layer 35 from the light emitting region 32 to the lens 17 is also n.

In the end portion 42 of the curved surface 40, the inclination (inclination angle $\theta$) of a tangent contacting the surface of the lens 17 is maximum on the curved surface 40. If the curved surface 40 is a spherical surface, the inclination angle $\theta$ is obtained using the distances h and r by $\sin\theta = 2rh/(r^2 + h^2)$. Considering a light beam that is refracted by the upper surface (curved surface 40) of the lens 17 with the inclination angle $\theta$ and is extracted in the front direction (the normal direction of the main surface 34 of the substrate 8), an incident angle $\alpha$ to the curved surface 40 of the lens 17 is represented based on Snell's law by $n \cdot \sin\alpha = \sin\theta$. Furthermore, an angle $\beta$ of the light beam with respect to the front direction is obtained by $\beta = \theta - \alpha$. On the other hand, if no lens 17 is provided, that is, if light refracted by the surface of $\theta = 0°$ is extracted in air, an emission angle $\gamma$, to air, of the light beam with the angle $\beta$ in the medium with the refractive index n is represented by $\sin\gamma = n \cdot \sin\beta$.

In the arrangement shown in Figs. 1 and 3, if h = 0.7r and n = 1.4, $\theta = 70.0°$, $\alpha = 42.2°$, $\beta = 27.8°$, and $\gamma = 40.8°$ are obtained. That is, if no lens 17 is provided, it is found that light exiting in a direction of 40.8° with respect to the front direction is refracted by the end portion 42 of the lens 17 and is extracted in the front direction. At each point from the vertex 41 to the end portion 42 of the curved surface 40 of the lens 17, the inclination angle of the curved surface 40 is between 0 and 70.0°. With this lens 17, light exiting in a direction of 0 to 40.8° with respect to the front direction in the case where no lens 17 is provided is extracted in the front direction. On the other hand, in the arrangement shown in Fig. 2, if h = 4 and n = 1.4, $\theta = 90°$, $\alpha = 45.6°$, $\beta = 44.4°$, and $\gamma = 78.5°$ are obtained.

In the embodiment, radiation intensity with which light is emitted in the front direction from the light emitting region 32 is represented as radiation intensity $I_0$. Furthermore, radiation intensity with which light is emitted in a direction of the angle $\beta$ from the light emitting region 32 is represented as radiation intensity $I_\beta$. In a case where light is emitted from the light emitting region 32 with the same radiation intensity independent of a radiation angle, that is, a case where $I_\beta = I_0$, the front extraction light amount is larger since the solid angle of light extracted in the front direction increases as the emission angle $\gamma$ calculated from the distances r and h of the lens 17 is increased. On the other hand, in an organic light emitting element used for the light emitting region 32, the radiation intensity from the light emitting region 32 is highest in the front direction, and may be lower as the radiation angle is larger. In particular, $I_\beta < I_0 \cdot \cos\beta$ may be satisfied within a range of $0 < \beta < \gamma$. If $I_\beta < I_0 \cdot \cos\beta$ is satisfied, it is found that the front extraction light amount is smaller as the emission angle $\gamma$ calculated from the distances r and h of the lens 17 is larger. This may be because the effect of using light (light in a region of the small angle $\beta$), with a relatively large light amount, of an angle close to the front direction is larger than the effect of increasing the light extraction angle.

Furthermore, in the organic light emitting element used for the light emitting region 32, as the radiation angle is larger, the color purity of light may deteriorate. As the angle with respect to the front direction is larger, the deterioration of the color purity of light emitted from the light emitting region 32 is larger. That is, as the emission angle $\gamma$ is larger, the color purity in the front direction deteriorates. That is, by comparing the arrangement shown in Fig. 1 with that shown in Fig. 2, the front extraction light amount can be increased and light with high color purity can be extracted in the arrangement shown in Fig. 1 in which the emission angle $\gamma$ is small. This effect is larger as the emission angle $\gamma$ is smaller. If the angle of the light beam in the light emitting layer of the organic light emitting element becomes 29° or more, the radiation intensity and the color purity may abruptly decrease, and thus light of an angle smaller than 29° in the light emitting layer may appropriately be extracted in the front direction. When the refractive index in the light emitting layer is 1.7, if no microlens is used, a light beam of 29° in the light emitting layer has a light beam angle of 55.5° in air. That is, when $\sin\gamma < \sin 55°$ is set, it is possible to obtain a large front extraction light amount and to suppress the deterioration of the light purity. By an experiment by the present inventors, it was found that when $\gamma < 55°$, it was possible to suppress the deterioration of the color purity, and to obtain an image of a suitable image quality while improving the light extraction efficiency (front extraction light amount).

Furthermore, the arrangement shown in Fig. 1 is compared with that shown in Fig. 3. In the arrangement shown in Fig. 1 and that shown in Fig. 3, the shapes of the lens 17 and the light emitting region 32 are the same. On the other hand, the distance H as the difference in height, in the normal direction of the main surface 34 of the substrate 8, between the light emitting region and the end portion 42 of the curved surface 40 of the lens 17 is different. In the arrangement shown in Fig. 1, a relationship of $a > r - H \cdot \tan\beta$ is satisfied. However, in the arrangement shown in Fig. 3, the relationship of $a > r - H \cdot \tan\beta$ is not satisfied. If light extracted in the front direction is tracked in the direction of the light emitting region 32 in consideration of refraction by the curved surface 40 of the lens 17, light refracted by the end portion 42 of the curved surface 40 of the lens 17 reaches the light emitting region 32 in the arrangement shown in Fig. 1. To the contrary, in the arrangement shown in Fig. 3, light refracted by the end portion 42 of the curved surface 40 of the lens 17 does not reach the light emitting region 32. That is, in the arrangement shown in Fig. 3, the outer edge portion of the lens 17 does not contribute to extraction of light in the front direction, and the area of the lens 17, that contributes to front extraction, is $\pi r'^2$. Since r' < r, the extraction light amount is larger in the arrangement shown in Fig. 1. That is, when the relationship of $a > r - H \cdot \tan\beta$ is satisfied, the front extraction

light amount can be improved.

As described above, in consideration of a case where the radiation intensity of light emitted from the light emitting region 32 is high in the front direction, when relationships given by expressions (1), (2), and (3) below are satisfied, it is possible to increase the front extraction light amount and extract light with high color purity.

$$h < r \quad ...(1)$$

$$\gamma < 55° \quad ...(2)$$

$$a > r - H \cdot \tan\beta \quad ...(3)$$

This makes it possible to efficiently extract light emitted from the light emitting region 32, and also suppress the deterioration of the color purity, thereby improving the performance of the light emitting device 10.

In the embodiment, if a plurality of medium layers (members) of different refractive indices are provided between the light emitting region 32 and the lens 17, the distances r, h, a, and H may be set such that the light entering the end portion 42 of the curved surface 40 of the lens 17 from the front direction reaches the light emitting region 32, in consideration of refraction at the interface between the layers of the different refractive indices, instead of satisfying the relationship of $a > r - H \cdot \tan\beta$. This arrangement can improve the extraction light amount. For example, in a case where a layer with a refractive index higher than that of the lens 17 is provided between the light emitting region 32 and the lens 17, satisfying the relationship of $a > r - H \cdot \tan\beta$ is a sufficient condition for the light beam that has entered from the front direction and has been refracted by the end portion of the microlens to reach the light emitting portion.

An arrangement in a case where a medium layer with a refractive index different from that of the lens 17 is provided between the light emitting region 32 and the lens 17 will be described with reference to Figs. 4 and 5. Figs. 4 and 5 are views each showing an example of an arrangement in a case where medium layers 35a and 35b of different refractive indices are provided between the light emitting region 32 and the lens 17. Assume that the refractive index of the medium layer 35a is $n_1$ and the refractive index of the medium layer 35b is $n_2$. For example, the medium layer 35a may be a color filter. For example, the medium layer 35b may be a protection layer for protecting the light emitting region 32 from water in the atmosphere.

In the arrangement shown in Fig. 4, the refractive indices have a magnitude relationship of $n_1 < n < n_2$. Considering the refraction of a light beam emitted in an oblique direction from the light emitting region 32, angles a, b, and c have a magnitude relationship of $a < c < b$ in accordance with the magnitude relationship among the refractive indices. When $c < b$, the light beam is bent in a direction close to the front direction at the interface between the medium layer 35a and the lens 17. Therefore, as shown in Fig. 4, the light emitted from the light emitting region 32 may exit in a direction close to the front direction from the lens 17 of the adjacent light emitting element. Thus, crosstalk may occur between the light emitting elements, thereby degrading image quality. Furthermore, since the radiation angle from the light emitting region 32 is large and light with low color purity may readily, visually be perceived, the color purity may deteriorate.

On the other hand, in the arrangement shown in Fig. 5, the refractive indices have a magnitude relationship of $n < n_1 < n_2$. Therefore, the angles a, b, and c have a magnitude relationship of $a < b < c$, and the light emitted in the oblique direction from the light emitting region 32 is refracted at the interface between the medium layer 35a and the lens 17 on the wide angle side, and is difficult to exit in the front direction. Therefore, it is possible to suppress the deterioration of the color purity.

As described above, when a layer with a refractive index lower than the refractive index n of the lens 17 is not arranged between the light emitting region 32 and the lens 17, it is possible to suppress crosstalk between the light emitting elements and the deterioration of the color purity. For example, in the arrangement shown in Fig. 5, the refractive index n of the lens 17 and the refractive index $n_1$ of the medium layer 35a may satisfy a relationship of $n \leq n_1$. Furthermore, the refractive index $n_2$ of the medium layer 35b arranged between the medium layer 35a and the light emitting region 32 may satisfy a relationship of $n \leq n_2$. In addition, the refractive index $n_2$ of the medium layer 35b may satisfy a relationship of $n_1 \leq n_2$.

In the arrangement shown in Fig. 1, it is found that light refracted by the end portion 42 on the right side of the lens 17 and extracted in the front direction is light from a position of a point P on the right side of the central portion of the light emitting region 32. On the other hand, in the arrangement shown in Fig. 2, the light refracted by the end portion 42 on the right side of the lens 17 and extracted in the front direction is emitted from the point P on the left side of the central portion of the light emitting region 32. In a case where the point P is on the left side of the central portion of the light emitting region 32, light of the large emission angle $\gamma$ is extracted in the front direction, as compared with a case where the point P is on the right side of the central portion of the light emitting region 32. As a result, the front extraction light amount becomes small and the color purity deteriorates. To cope with this, a condition for the end portion 42 to be on the same side of the light emitting

region 32 as that of the position where light that passes through the end portion 42 of the curved surface 40 of the lens 17 is emitted is that r - H·tanβ > 0 is satisfied. That is, when the shape of the lens 17, the shape of the light emitting region 32, and the positions of the lens 17 and the light emitting region 32 are set to satisfy r - H·tanβ > 0, it is possible to increase the front extraction light amount and extract light with high color purity.

The example in which the curved surface 40 forming the upper surface of the lens 17 is part of a spherical surface has been described above. The curved surface 40 need not match part of a spherical surface and may be part of an aspherical surface. In this case, a surface obtained by approximating the upper surface of the lens 17 to part of a spherical surface may be regarded as the curved surface 40. In the lens 17, the boundary between the curved surface 40 and a portion other than the curved surface 40 may be ambiguous in, for example, a case where the inclination of the surface of the microlens gently changes from the curved surface 40 to the portion other than the curved surface 40. In such case, for example, a portion where the inclination angle θ is maximum may be set as the end portion 42 of the curved surface 40. The above-described inflection point or the like corresponds to this. In a case where the curved surface 40 of the lens 17 is not part of a spherical surface and the curvature of the end portion 42 is smaller than that of the spherical surface or a case where the curved surface 40 is part of an aspherical surface, a surface obtained by approximating the actual shape to part of a spherical surface may be set as the curved surface 40. For example, a virtual spherical surface passing through the vertex 41 of the lens 17 and a position on the lens 17 at which the distance from the vertex 41 in the normal direction of the main surface 34 of the substrate 8 is h/2 may be derived and the distance r may be defined based on the virtual spherical surface. In orthogonal projection to the main surface 34 of the substrate 8, when $r_2$ represents the distance between the vertex 41 of the lens 17 and the point at which the distance from the vertex 41 of the lens 17 in the normal direction is h/2, the distance r may be defined by $r = (2 \times r_2^2 - h^2/2)^{1/2}$

A more detailed example of the arrangement of the light emitting device 10 will be described with reference to Fig. 6. Fig. 6 is a sectional view passing through the vertex 41 of the curved surface 40 of the lens 17. An example of an organic light emitting element (a light emitting element containing an organic light emitting material in the light emitting region 32) also called an organic electro luminescence element (organic EL element) will now be described but the arrangement of the light emitting device 10 is not limited to this. For example, the light emitting element may be an inorganic EL element containing an inorganic light emitting material in the light emitting region 32. For example, a light emitting diode or the like may be used for the light emitting region 32.

As shown in Fig. 6, the light emitting device 10 can include the substrate 8, electrodes 9, an organic layer 20, an electrode 11, an insulating layer 12, a protection layer 13, a planarizing layer 14, color filters 15, a planarizing layer 16, and the lenses 17. The electrodes 9 are arranged on the substrate 8. The electrodes 9 can also be called lower electrodes. The organic layer 20 includes a light emitting layer containing a light emitting material. Part of the organic layer 20 (light emitting layer) functions as the above-described light emitting region 32. The organic layer 20 is arranged between the substrate 8 and the lenses 17 to cover the electrodes 9. The electrode 11 is arranged on the organic layer 20. The electrode 11 can also be called an upper electrode. The organic layer 20 (light emitting layer) emits light by a potential difference between the electrodes 9 and 11. The insulating layer 12 is arranged between the electrodes 9 so as to insulate the adjacent electrodes 9 from each other. The insulating layer 12 can also be called a bank. The insulating layer 12 is arranged in the outer edge portion on the electrodes 9. The central portion of each electrode 9, that is not covered with the insulating layer 12, is in contact with the organic layer 20. A portion of the organic layer 20, that is in contact with the electrode 9, can be the above-described light emitting region 32. Therefore, as shown in Fig. 6, the plurality of light emitting regions 32 respectively corresponding to the plurality of electrodes 9 can be arranged in the light emitting device 10. The protection layer 13 is arranged on the electrode 11, and the planarizing layer 14 is arranged on the protection layer 13. The color filters 15 can be arranged on the planarizing layer 14 to respectively correspond to the plurality of light emitting regions 32. The planarizing layer 16 is arranged on the color filters 15. The lenses 17 are arranged on the planarizing layer 16. The lenses 17 are respectively arranged to correspond to the plurality of light emitting regions 32.

A material used for the substrate 8 is not particularly limited as long as the material can support the respective components of the light emitting device 10, such as the electrodes 9, the organic layer 20, and the electrode 11. For example, glass, plastic, or silicon may be used as the material of the substrate 8. A switching element such as a transistor, a wiring pattern, an interlayer insulating film, and the like may be provided in the substrate 8.

The electrode 9 may be transparent or opaque. If the electrode 9 is opaque, the material of the electrode 9 may be a metal material whose reflectance of the wavelength of light emitted from the light emitting region 32 is 70% or more. For example, as the material of the electrode 9, a metal such as Al or Ag or an alloy obtained by adding Si, Cu, Ni, Nd, or the like to Al or Ag may be used. As the material of the electrode 9, ITO, IZO, AZO, IGZO, or the like may be used. The electrode 9 may be a stacked electrode with a barrier electrode made of a metal such as Ti, W, Mo, or Au, or an alloy thereof, or a stacked electrode with a transparent oxide film electrode made of ITO, IZO, or the like as long as the reflectance is higher than a predetermined (desired) reflectance.

If the electrode 9 is transparent, a reflective layer may be provided between the electrode 9 and the substrate 8. As the material of the transparent electrode 9, for example, ITO, IZO, AZO, IGZO, or the like may be used. To optimize an optical distance (to be described later), an arrangement in which an insulating film is provided between the reflective layer

and a transparent conductive film may be adopted as the arrangement of the electrode 9.

The electrode 11 is transmissive. The electrode 11 may be a semi-transmissive electrode having a characteristic (that is, a transflective property) of transmitting part of light that has reached the surface of the electrode 11 and reflecting the remaining part of the light. As the material of the electrode 11, for example, a transparent material such as a transparent conductive oxide may be used. As the material of the electrode 11, a semi-transmissive material of a single metal (Al, Ag, Au, or the like), an alkali metal (Li, Cs, or the like), an alkali earth metal (Mg, Ca, Ba, or the like), or an alloy material containing these metal materials may be used. If a semi-transmissive material is used as the material of the electrode 11, an alloy containing Mg or Ag as a main component may be used as a semi-transmissive material. The electrode 11 may have a stacked structure including a plurality of layers made of the above-described materials as long as it has an appropriate transmittance. In the arrangement shown in Fig. 6, the electrode 11 common to the plurality of light emitting regions 32 is provided. However, the present invention is not limited to this, and a plurality of electrodes 11 respectively corresponding to the plurality of light emitting regions 32 may be arranged.

One of the electrodes 9 and 11 functions as an anode, and the other of the electrodes 9 and 11 functions as a cathode. For example, the electrode 9 may function as an anode and the electrode 11 may function as a cathode. Alternatively, the electrode 9 may function as a cathode and the electrode 11 may function as an anode.

The organic layer 20 can be formed by a known technique such as a deposition method or a spin coating method. The organic layer 20 may be formed from a plurality of layers. If the organic layer 20 is an organic compound layer, the organic layer 20 includes at least one of a hole injection layer, a hole transport layer, an electron blocking layer, a hole blocking layer, an electron transport layer, an electron injection layer, and the like in addition to the light emitting layer.

The light emitting layer emits light when holes injected from the anode and electrons injected from the cathode are recombined in the light emitting layer. The light emitting layer may include a single layer or a plurality of layers. If, for example, a light emitting layer containing a red light emitting material, a light emitting layer containing a green light emitting material, and a light emitting layer containing a blue light emitting material are combined, light beams (red light, green light, and blue light) from the respective light emitting layers can be mixed to obtain white light. Two kinds of light emitting layers whose light emission colors have a complimentary color relationship (for example, a light emitting layer containing a blue light emitting material and a light emitting layer containing a yellow light emitting material) may be combined. In the light emitting device 10 shown in Fig. 6, each light emitting region 32 emits white light and the light is colored in the color filter 15. However, the present invention is not limited to this. A material contained in a light emitting layer and the arrangement of the light emitting layer may be different for each light emitting region 32 so that the light emitting layer emits light of a different color for each light emitting region 32. In this case, the light emitting layer may be patterned for each light emitting region 32.

The light emitting device 10 may include a first reflective layer arranged between the main surface 34 of the substrate 8 and the organic layer 20 including the light emitting layer, and a second reflective layer arranged between the lens 17 and the organic layer 20 including the light emitting layer. The first reflective layer may be the electrode 9, or a metal layer arranged between the electrode 9 and the substrate 8. The second reflective layer may be the electrode 11, or a semi-transmissive reflective layer arranged between the electrode 11 and the lens 17 and having a characteristic (that is, a transflective property) of transmitting part of light that has reached the surface and reflecting the remaining part of the light.

To optimize the optical distance between the first reflective layer and the light emitting region 32 of the organic layer 20 including the light emitting layer with respect to a desired angle $\theta_{eml}$ in the light emitting layer, equation (4) below is satisfied. In equation (4), Lr [nm] represents an optical path length (optical distance) from the upper surface of the first reflective layer to the light emission position of the organic layer 20, $\Phi_r$ [rad] represents a phase shift when light of a wavelength $\lambda$ [nm] is reflected by the first reflective layer, and m represents an integer of 0 or more. The film thickness of the electrode 9, that of the first reflective layer, and that of the organic layer 20 are adjusted so as to satisfy equation (4).

$$Lr = (2m - \Phi_r/\pi)) \times (\lambda/4) \times (1/\cos\theta_{eml}) \qquad ...(4)$$

Similarly, to optimize the optical distance between the second reflective layer and the light emitting region 32 of the organic layer 20 including the light emitting layer with respect to the desired angle $\theta_{eml}$ in the light emitting layer, equation (5) below is satisfied. In equation (5), Ls [nm] represents an optical path length (optical distance) from the lower surface of the second reflective layer to the light emission position of the organic layer 20, $\Phi_s$ [rad] represents a phase shift when the light of the wavelength $\lambda$ [nm] is reflected by the second reflective layer, and m represents an integer of 0 or more.

$$Ls = (2m - (\Phi_s/\pi)) \times (\lambda/4) \times (1/\cos\theta_{eml}) = -(\Phi_s/\pi) \times (\lambda/4) \qquad ...(5)$$

An optical path length L[nm] between the first reflective layer and the second reflective layer may satisfy equation (6) below. In equation (6), $\Phi$ is a sum of the phase shifts $\Phi_r$ and $\Phi_s$.

$$L = Lr + Ls$$

$$= (2m - \Phi/\pi) \times (\lambda/4) \times (1/\cos\theta_{eml}) \quad ...(6)$$

In the embodiment, even if each of the optical path lengths Ls, Lr, and L deviates from each of equations (4) to (6) by about $\pm\lambda/8$ or about 20 nm, this falls within an allowable range. It may be difficult to specify the light emission position in the light emitting layer of the organic layer 20. Thus, in equations (4) to (6) above, the interface on the first reflective layer side or the second reflective layer side of the light emitting layer of the organic layer 20 may be used instead of the light emission position. In consideration of the above-described allowable range, even if the interface is used instead, an effect of intensifying light in the front direction can be obtained.

If no lens 17 is provided, it is possible to improve the light amount in the front direction by setting the optical distance of the light emitting layer in the front direction, that is, $\theta_{eml} = 0°$, and optimizing the film thickness so as to satisfy equations (4) to (6). On the other hand, if the lens 17 is provided as in this embodiment, light refracted by the curved surface 40 of the lens 17 and extracted in the front direction is obtained by adding light whose light beam angle in air falls within a range of 0° to $\gamma$° in the case where no lens 17 is provided, as described above. Therefore, when $n_{eml}$ represents the refractive index of the light emitting layer, it is considered to be able to improve the extraction light amount in the front direction more by optimizing the film thickness with respect to the angle $\theta_{eml}$ that satisfies $0 < \sin\theta_{eml} < \sin\gamma/n_{eml}$ than by optimizing the film thickness with respect to $\theta_{eml} = 0°$

Therefore, as described in this embodiment, if the lens 17 is provided, in consideration of the above-described allowable range, the optical path length L [nm] between the first reflective layer and the second reflective layer may satisfy:

$$(2m - \Phi/\pi) \times (\lambda/4) \times (1/\cos\theta_{eml}) - \lambda/8 < L <(2m-\Phi/\pi) \times (\lambda/4) \times (1/\cos\theta_{eml}) + \lambda/8$$

where $\lambda$ [nm] represents the peak wavelength of the light that passes through the lens 17, m represents an integer of 0 or more, ® [rad] represents the sum of the phase shifts when the light of the wavelength $\lambda$ is reflected by the first reflective layer and the second reflective layer, and $\theta_{eml}$ [°] represents an angle that satisfies $0 < \sin\theta_{eml} < \sin\gamma/n_{eml}$ when $n_{eml}$ represents the refractive index of the light emitting layer. For example, the optical path length L[nm] between the first reflective layer and the second reflective layer may satisfy:

$$(2m - \Phi/\pi) \times (\lambda/4) < L < (2m - \Phi/\pi) \times (\lambda/4) \times (1/\cos\theta_{eml}) + \lambda/8$$

This improves the extraction efficiency of light emitted from the light emitting layer. In this case, $\theta_{eml}$ may arbitrarily be set within a range satisfying $0 < \sin\theta_{eml} < \sin\gamma/n_{eml}$ so as to optimize the color purity and the viewing angle characteristic.

The protection layer 13, the planarizing layer 14, the color filters 15, and the planarizing layer 16 form the above-described medium layer 35. The protection layer 13 is a dielectric layer. The protection layer 13 is transmissive. Furthermore, the protection layer 13 may contain an inorganic material having a low permeability for oxygen and water from the outside of the light emitting device 10. For example, the protection layer 13 may be formed using an inorganic material such as silicon nitride (SiN), silicon oxynitride (SiON), silicon oxide ($SiO_x$), aluminum oxide ($Al_2O_3$), or titanium oxide ($TiO_2$). In terms of the protection performance, the protection layer 13 may be made of an inorganic material such as SiN, SiON, or $Al_2O_3$. A chemical vapor deposition (CVD) method, an atomic layer deposition (ALD) method, a sputtering method, or the like can be used to form the protection layer 13.

The protection layer 13 can have a single-layer structure using the above-described material or a stacked structure using the above-described materials in combination as long as the protection layer 13 has sufficient water block performance. For example, the protection layer 13 may have a stacked structure of a layer of silicon nitride formed using the CVD method and another layer (for example, $Al_2O_3$) having a high density formed using the ALD method. Furthermore, the protection layer 13 may include an organic layer as long as it has water block performance. For example, polyacrylate, polyimide, polyester, epoxy, or the like can be used for the organic layer. In addition, in the arrangement shown in Fig. 6, the protection layer 13 common to the plurality of light emitting regions 32 is provided but a plurality of protection layers 13 respectively corresponding to the plurality of light emitting regions 32 may be arranged.

The lens 17 can be formed by an exposure process and a developing process. More specifically, a material film (for example, a photoresist film) of the lens 17 is formed, and the photoresist film is exposed and developed using a mask including a continuous change in gradation. As the mask used to form the lens 17, a gray mask can be used. An area gradation mask that allows light irradiation with a continuous change in gradation on the imaging plane by changing the density distribution of dots of a light shielding film with a resolution equal to or smaller than the resolution of an exposure device can be used as the mast used to form the lens 17. The lens shape can be adjusted by etching back the lens 17 formed by the exposure process and the developing process. As describe above, the upper surface of the lens 17 need

only have the curved surface 40 that satisfies expressions (1) to (3), and the curved surface 40 may be part of a spherical surface or an aspherical surface.

The light emitting element is formed by a combination of the light emitting region 32, the curved surface 40 of the lens 17, and the like. If a plurality of light emitting elements are provided, the planar arrangement (the arrangement when viewed from the normal direction of the main surface 34 of the substrate 8) of the plurality of light emitting elements may be any of a stripe arrangement, a square arrangement, a delta arrangement, a pentile arrangement, and a Bayer arrangement. Figs. 7A to 7C are plan views when viewing the light emitting device 10 from the side of the lens 17, and each show an example of the planar arrangement of the plurality of light emitting elements. Fig. 7A shows an example of the delta arrangement. Fig. 7B shows an example of the stripe arrangement. Fig. 7C shows an example of the Bayer arrangement. In the embodiment, consider a case where the light emitting device 10 is used as a display panel, and one pixel (main pixel) includes a plurality of sub-pixels having different corresponding color components (for example, a sub-pixel that performs red display, a sub-pixel that performs green display, and a sub-pixel that perform blue display). In this case, as shown in Fig. 7B, a plurality of light emitting elements may be arranged in one sub-pixel. The size and shape of the curved surface 40 of the lens 17 may appropriately be set in accordance with the planar arrangement of the plurality of light emitting elements. For example, if the delta arrangement is adopted, an area occupied by the curved surface 40 of the lens 17 with respect to the sub-pixel can be set large, thereby improving light extraction efficiency.

In the arrangements shown in Figs. 7A to 7C, the planar shape of the light emitting region 32 (the shape when viewed from the normal direction of the main surface 34 of the substrate 8) is a circular shape but the planar shape of the light emitting region 32 is not limited to this. The planar shape of the light emitting region 32 may be, for example, a polygonal shape such as a rectangular or hexagonal shape. However, if the planar shape of the light emitting region 32 is a circular shape, the relationship of the inclination angle in a direction from the end portion of the light emitting region 32 to the end portion 42 of the curved surface 40 of the lens 17 is the same in all sections obtained by a plane in the normal direction of the main surface 34 of the substrate 8 that passes through the vertex 41 of the curved surface 40. Therefore, it can be easy to design the light emitting device 10.

As shown in Fig. 8, the lenses 17 may be formed so that the end portion 42 of the curved surface 40 forming the upper surface of each lens 17 has a thickness (parts of the adjacent lenses 17 overlap each other). In this case, the end portion 42 of the curved surface 40 can be a set of portions (parallel to the main surface 34 of the substrate 8) where the inclination between the adjacent lenses 17 is 0°. In this case as well, it is possible to improve light extraction efficiency by satisfying expressions (1) to (3), and extract light with high color purity.

As described above, an arrangement in which the lenses 17 transmit light beams of different colors may be adopted. The light emitting device 10 allows full-color display. As a method of implementing full-color display, a method of using the color filters 15 and the light emitting layer that emit white light may be adopted. Since the plurality of light emitting regions 32 can share the light emitting layer, a manufacturing process of the light emitting layer is easier than in a case where the light emitting layer is patterned to emit light of a different color for each light emitting region 32. However, the light emitting layer may be patterned so that the plurality of light emitting regions 32 emit light beams of different colors. Furthermore, the above-described optical path length L (the optical light length Lr or Ls) between the first reflective layer and the second reflective layer may be different for each of the light emitting regions 32 that emit light beams of different colors.

In this embodiment, the color filters 15 are provided on the planarizing layer 14. However, the color filters 15 may be provided on the protection layer 13. For example, the color filters 15 and the protection layer 13 may be continuous without arranging the planarizing layer 14. Alternatively, the color filters 15 and the protection layer 13 may be integrated. The color filters 15 may be formed on a support substrate different from the substrate 8 and this substrate may be bonded so as to oppose the protection layer 13, thereby forming the color filters 15 of the light emitting device 10.

The planarizing layer 14 is provided to planarize unevenness of the upper surface of the protection layer 13. By arranging the planarizing layer 14, the color filters 15 can be formed to be accurately aligned with the respective light emitting regions 32 using a photolithography process. As described above, by integrating the color filters 15 and the protection layer 13 without arranging the planarizing layer 14, the color filters 15 can be formed to be accurately aligned with the respective light emitting regions 32 using a photolithography process.

In the arrangement shown in Fig. 6, color filters 15r, 15g, and 15b may be color filters configured to transmit light beams of different colors. For example, the color filter 15r may transmit red light, the color filter 15g may transmit green light, and the color filter 15b may transmit blue light. Some or all of the plurality of color filters 15 need not be arranged. In this case, when the light emitting layer of the organic layer 20 is formed for each light emitting element, and the light emitting regions 32 emit light beams of different colors, full-color display is possible.

Furthermore, in this embodiment, the lenses 17 are provided on the planarizing layer 16. The planarizing layer 16 is provided to planarize unevenness of the upper surfaces of the color filters 15. However, the lenses 17 may be provided on the color filters 15. In this case, the planarizing layer 16 need not be arranged. Alternatively, the lenses 17 and the color filters 15 may be integrated.

Furthermore, the lenses 17 may be provided on the protection layer 13 without arranging the color filters 15 and

the planarizing layers 14 and 16. For example, the lenses 17 and the protection layer 13 may be integrated. If the lenses 17 and the protection layer 13 are integrated, the distance from the lens 17 to the light emitting region 32 can be shortened, as compared with a case where the lenses 17 are formed on another substrate and this substrate is bonded so as to oppose the protection layer 13. As a result, the solid angle of light entering the lens 17 from the light emitting region 32 can be increased, thereby improving light extraction efficiency. By integrating the lenses 17 and the protection layer 13, the curved surface 40 of each lens 17 can be accurately aligned with the corresponding light emitting region 32. For example, by integrating the color filters 15, the lenses 17, and the protection layer 13, the light emitting regions 32, the color filters 15, and the lenses 17 can accurately be aligned, respectively.

The stacking order of the color filters 15 and the lenses 17 can appropriately be selected. In the arrangement shown in Fig. 6, the color filters 15 are provided on the side of the light emitting regions 32 with respect to the lenses 17. In this arrangement, light emitted from the light emitting region 32 passes through the color filter 15 before entering the lens 17. Thus, light (light having a large emission angle from the light emitting portion) that causes deterioration of the color purity passes through the color filter 15 over a relatively long distance. Therefore, it is possible to suppress the deterioration of the color purity when observing the light emitting device 10 from the oblique direction.

The light emitting device 10 may be manufactured by forming the color filters 15 and the lenses 17 on a support substrate different from the substrate 8 and bonding the substrate so as to oppose the substrate 8 including the light emitting regions 32. When the color filters 15 and the lenses 17 are formed separately from the organic layer 20 (light emitting layer), the degree of freedom of a processing method (for example, a temperature and the like) when forming the color filters 15 and the lenses 17 increases, thereby making it possible to increase the degree of freedom of the design of the color filters 15 and the lenses 17. The color filters 15 and the lenses 17 may be continuously formed on one support substrate, or the color filters 15 and the lenses 17 may be formed on different support substrates. The lenses 17 and the color filters 15 can be coupled to the substrate 8 using a coupling member such as an adhesive. The coupling member may be arranged on the planarizing layer 14, or may be arranged on the protection layer 13 in a case where the planarizing layer 14 is not arranged.

If the lenses 17 are formed on a support substrate different from the substrate 8 and the substrate is bonded to oppose the substrate 8 including the light emitting regions 32, the lenses 17 may be fixed to the substrate 8 by a coupling member such as an adhesive in the end portion of the light emitting device 10 so as to provide a space between the lenses 17 and the protection layer 13 (or the color filters 15). In this case, the space may be filled with a resin. In this case, each lens 17 can be convex downward, unlike the above-described arrangement. In this case, the refractive index of the resin may be lower than the refractive index n of the lens 17.

Examples of the light emitting device 10 will be described below.

Example 1

First, aluminum was formed on a substrate 8 and patterned, thereby forming a plurality of electrodes 9. Next, silicon oxide of a film thickness of 65 nm was formed as a material film of an insulating layer 12 to cover each of the electrodes 9. In the formed material film, an opening portion was formed in the central portion of each of the electrodes 9 to expose the electrode 9, thereby forming the insulating layer 12. The shape of the opening portion that exposes the electrode 9 was a circular shape having a radius of 3.0 μm. As described above, the opening portion formed in the insulating layer 12 finally corresponded to a light emitting region 32. That is, in orthogonal projection to a main surface 34 of the substrate 8, the size and shape of the opening portion may match the size and shape of the light emitting region 32.

After the insulating layer 12 was formed, an organic layer 20 was formed on the electrodes 9 and the insulating layer 12. More specifically, a hole injection layer was formed to a thickness of 3 nm by compound 1 (see drawings below) (the same applies to other compounds). On the hole injection layer, a hole transport layer was formed to a thickness of 15 nm by compound 2. On the hole transport layer, an electron blocking layer was formed to a thickness of 10 nm by compound 3. Next, a first light emitting layer was formed to a thickness of 10 nm such that compound 4 serving as a host material was contained in a weight ratio of 97% and compound 5 serving as a light emitting dopant was contained in a weight ratio of 3%. A second light emitting layer was formed to a thickness of 10 nm such that compound 4 serving as a host material was contained in a weight ratio of 98% and compounds 6 and 7 serving as light emitting dopants were respectively contained in a weight ratio of 1%. On the second light emitting layer, an electron transport layer was formed to a thickness of 110 nm by compound 8. On the electron transport layer, an electron injection layer was formed to a thickness of 1 nm by lithium fluoride.

[Chemical 1]

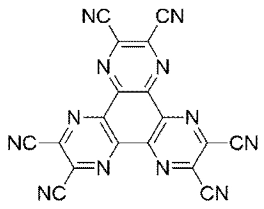

COMPOUND 1

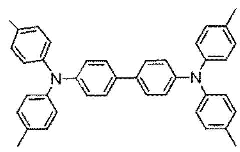

COMPOUND 2

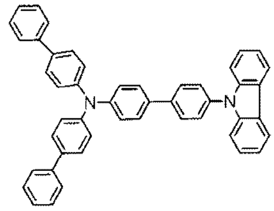

COMPOUND 3

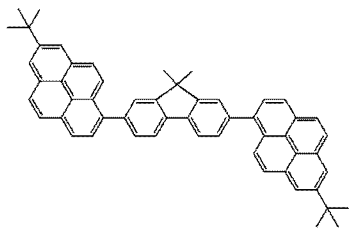

COMPOUND 4

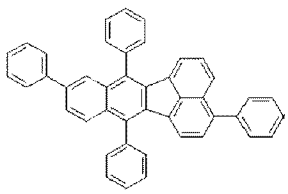

COMPOUND 5

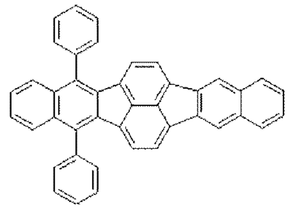

COMPOUND 6

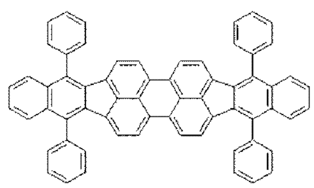

COMPOUND 7

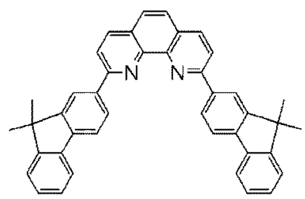

COMPOUND 8

After the organic layer 20 was formed, an Mg/Ag alloy was formed to a thickness of 10 nm as an electrode 11. The ratio of Mg and Ag was 1 : 1. After that, as a protective layer 13, SiN with a refractive index of 1.97 was formed to a thickness of 1.5 μm on the electrode 11 by the CVD method. Next, a planarizing layer 14 with a refractive index of 1.55 was formed to a thickness of 300 nm on the protection layer 13 by the spin coating method.

Next, color filters 15 with a refractive index of 1.65 were formed to a thickness of 1.6 μm on the planarizing layer 14. A color filter 15r was a color filter configured to transmit red light, a color filter 15g was a color filter configured to transmit green light, and a color filter 15b was a color filter configured to transmit blue light. After the color filters 15 were formed, a planarizing layer 16 with a refractive index of 1.55 was formed to a thickness of 200 nm on the color filters 15 by the spin coating method.

Next, a lens 17 with a refractive index of 1.52 was formed by an exposure process and a developing process on the planarizing layer 16. A curved surface 40 of the lens 17 was part of a spherical surface. Furthermore, a distance h as a difference in height between a vertex 41 and an end portion 42 of the curved surface 40 in the normal direction of the main surface 34 of the substrate 8 was 2.3 μm, and a distance r between the vertex 41 and the end portion of the curved surface 40 in orthogonal projection to the main surface 34 of the substrate 8 was 3.4 μm.

In the light emitting device 10 manufactured in this way, an inclination angle $\theta$ and an incident angle $\alpha$ of the end portion 42 of the lens 17 (curved surface 40) were calculated by $\sin\theta = 2rh/(r^2 + h^2)$ and $n \cdot \sin\alpha = \sin\theta$, and $\theta = 68.2°$ and $\alpha = 37.6°$ were obtained. In addition, an angle $\beta$ was $\beta = \theta - \alpha = 30.5°$ and an emission angle $\gamma$ was 50.5° obtained by $\sin\gamma = n \cdot \sin\beta$. Therefore, the manufactured light emitting device 10 satisfied relationships of $h < r$ and $\gamma < 55°$.

Furthermore, a distance H as a difference in height, in the normal direction of the main surface 34 of the substrate 8, between the light emitting region 32 and the end portion 42 of the curved surface 40 of the lens 17 was 3.6 μm. Therefore, $r - H \cdot \tan\beta = 1.28$ μm was calculated. A distance a that is 1/2 of the width of the light emitting region 32 in a direction parallel to the main surface 34 of the substrate 8 was 3.0 μm. Therefore, the manufactured light emitting device 10 satisfied a relationship of $a > r - H \cdot \tan\beta$. As a result, the manufactured light emitting device 10 was able to increase a front extraction light amount and extract light with high color purity.

Example 2

A light emitting device 10 according to Example 2 will be described next. In Example 1, the shape of the light emitting region 32 was a circular shape having a radius of 3.0 μm in orthogonal projection to the main surface 34 of the substrate 8 and the thickness of the planarizing layer 16 was 200 nm. This example assumed that the shape of a light emitting region 32 was a circular shape having a radius of 1.0 μm in orthogonal projection to a main surface 34 of a substrate 8 and the thickness of a planarizing layer 16 was 2.0 μm. The remaining components were the same as in Example 1. Fig. 9 is a sectional view showing an example of the arrangement of the light emitting device 10 according to this example and passing through a vertex 41 of a curved surface 40 of a lens 17.

Since a distance h, a distance r, and a refractive index n of the lens 17 were the same as in Example 1, an inclination angle $\theta$, an incident angle $\alpha$, an angle $\beta$, and an emission angle $\gamma$ were $\theta = 68.2°$, $\alpha = 37.6°$, $\beta = 30.5°$, and $\gamma = 50.5°$, as in Example 1. Therefore, the manufactured light emitting device 10 satisfied relationships of $h < r$ and $\gamma < 55°$.

Furthermore, a distance H as a difference in height, in the normal direction of the main surface 34 of the substrate 8, between the light emitting region 32 and an end portion 42 of the curved surface 40 of the lens 17 was 5.4 μm. Therefore, $r - H \cdot \tan\beta = 0.22$ μm was calculated. A distance a that is 1/2 of the width of the light emitting region 32 in a direction parallel to the main surface 34 of the substrate 8 was 1.0 μm. Therefore, the manufactured light emitting device 10 satisfied a relationship of $a > r - H \cdot \tan\beta$.

In the embodiment, a = 1.0 μm was obtained while satisfying relationships indicated by expressions (1) to (3), and the light emitting region 32 can be decreased while maintaining a front extraction light amount. That is, since the area of the light emitting region 32 can be decreased while maintaining a current density necessary to implement desired luminance, it is possible to decrease an input current amount for each light emitting element. That is, it is possible to further improve current use efficiency by using the arrangement described in Example 2, thereby obtaining the effect of suppressing power consumption.

Example 3

Next, a light emitting device 10 according to Example 3 will be described. In Example 1, the distance h, in the normal direction of the main surface 34 of the substrate 8, between the vertex 41 and the end portion 42 of the curved surface 40 of the lens 17 was 2.3 μm. However, in this example, a distance h was 1.8 μm. The remaining components were the same as in Example 1. Fig. 10 is a sectional view showing an example of the arrangement of the light emitting device 10 according to this example and passing through a vertex 41 of a curved surface 40 of a lens 17.

When an inclination angle $\theta$, an incident angle $\alpha$, an angle $\beta$, and an emission angle $\gamma$ of the light emitting device 10 in this example were calculated, $\theta = 55.8°$, $\alpha = 33.0°$, $\beta = 22.8°$, and $\gamma = 36.1°$ were obtained. Therefore, the manufactured light emitting device 10 satisfied relationships of $h < r$ and $\gamma < 55°$.

Similar to Example 1, a distance H as a difference in height, in the normal direction of a main surface 34 of a substrate 8, between a light emitting region 32 and an end portion 42 of the curved surface 40 of the lens 17 was 3.6 μm. Therefore, $r - H \cdot \tan\beta = 1.88$ μm was calculated. A distance a that is 1/2 of the width of the light emitting region 32 in a direction parallel to the main surface 34 of the substrate 8 was 3.0 μm. Therefore, the manufactured light emitting device 10 satisfied a relationship of $a > r - H \cdot \tan\beta$.

In this example, $\gamma$ was decreased while satisfying relationships indicated by expressions (1) to (3). Therefore, it was possible to further improve a front extraction light amount. From the viewpoint of obtaining such effect, for example, $\gamma$ may be 45° or smaller, or 35° or smaller.

Example 4

Next, a light emitting device 10 according to Example 4 will be described. In this example, the distance between the first reflective layer and the second reflective layer was made different for each light emitting region 32. Furthermore, the shape of the light emitting region 32 was a circular shape having a radius of 2.0 μm in orthogonal projection to a main surface 34 of a substrate 8. The remaining components were the same as in Example 1. Fig. 11 is a sectional view showing the light emitting device 10 according to this example and passing through a vertex 41 of a curved surface 40 of a lens 17.

A method of manufacturing the light emitting device 10 according to this example will be described. First, aluminum was formed on the substrate 8 and patterned, thereby forming a plurality of reflective layers 18. Next, insulating films 19 having different film thicknesses for respective light emitting elements (light emitting regions 32) were formed to cover the reflective layers 18 by repeatedly forming an insulating layer using silicon oxide and patterning it. More specifically, the insulating film 19 having a film thickness of 75 nm was formed in a portion on which a color filter 15r configured to transmit red light was to be provided. The insulating film 19 having a film thickness of 130 nm was formed in a portion on which a color filter 15g configured to transmit green light was to be provided. The insulating film 19 having a film thickness of 190 nm was formed in a portion on which a color filter 15b configured to transmit blue light was to be provided.

Next, an ITO film was formed and patterned, thereby forming electrodes 9 on the insulating films 19. As steps after the electrodes 9 were formed on the insulating films 19, the same steps as in Example 1 were used to form the light emitting device 10. However, the shape of an opening portion that was formed in an insulating layer 12 to expose the electrode 9, that is, the shape of the light emitting region 32 was a circular shape having a radius of 2.0 μm in orthogonal projection to the main surface 34 of the substrate 8. Furthermore, in the organic layer 20, a hole transport layer had a film thickness of 36 nm, and an electron transport layer had a film thickness of 45 nm. In addition, a protection layer 13 had a thickness of 1.5 μm.

In this example, the reflective layer 18 corresponded to the above-described first reflective layer, and the electrode 11 corresponded to the above-described second reflective layer. The optical path length L between the first reflective layer and the second reflective layer of each light emitting element including the light emitting region 32 was set in accordance with a desired color component (a color component of externally extracted light). Thus, it was possible to improve the intensity and color purity of light emitted in the front direction from the light emitting device 10. In the arrangement described in Example 4, it was possible to further improve the current use efficiency of the light emitting region 32 and extract light with high color purity.

Application examples in which the light emitting device 10 of this embodiment is applied to a display device, a photoelectric conversion device, an electronic apparatus, an illumination device, a moving body, and a wearable device will be described here with reference to Figs. 12 to 18A and 18B.

Fig. 12 is a schematic view showing an example of the display device using the light emitting device 10 of this embodiment. A display device 1000 can include a touch panel 1003, a display panel 1005, a frame 1006, a circuit board 1007, and a battery 1008 between an upper cover 1001 and a lower cover 1009. Flexible printed circuits (FPCs) 1002 and 1004 are respectively connected to the touch panel 1003 and the display panel 1005. Active elements such as transistors are arranged on the circuit board 1007. The battery 1008 is unnecessary if the display device 1000 is not a portable apparatus. Even when the display device 1000 is a portable apparatus, the battery 1008 need not be provided at this position. The light emitting device 10 can be applied to the display panel 1005. The light emitting device 10 functioning as the display panel 1005 is connected to the active elements such as transistors arranged on the circuit board 1007 and operates.

The display device 1000 shown in Fig. 12 can be used for a display unit of a photoelectric conversion device (image capturing device) including an optical unit having a plurality of lenses, and an image sensor for receiving light having passed through the optical unit and photoelectrically converting the light into an electric signal. The photoelectric conversion device can include a display unit for displaying information acquired by the image sensor. In addition, the display unit can be either a display unit exposed outside the photoelectric conversion device, or a display unit arranged in the finder. The photoelectric conversion device can be a digital camera or a digital video camera.

Fig. 13 is a schematic view showing an example of the photoelectric conversion device using the light emitting device 10 of this embodiment. A photoelectric conversion device 1100 can include a viewfinder 1101, a rear display 1102, an operation unit 1103, and a housing 1104. The photoelectric conversion device 1100 can also be called an image capturing device. The light emitting device 10 according to this embodiment can be applied to the viewfinder 1101 or the rear display 1102 as a display unit. In this case, the light emitting device 10 can display not only an image to be captured but also environment information, image capturing instructions, and the like. Examples of the environment information are the intensity and direction of external light, the moving velocity of an object, and the possibility that an object is covered with an obstacle.

The timing suitable for image capturing is a very short time in many cases, so the information should be displayed as soon as possible. Therefore, the light emitting device 10 in which the organic light emitting element such as an organic EL element using an organic light emitting material is arranged may be used for the viewfinder 1101 or the rear display 1102. This is so because the organic light emitting material has a high response speed. The light emitting device 10 using the organic light emitting material can be used for the apparatuses that require a high display speed more suitably than for the liquid crystal display device.

The photoelectric conversion device 1100 includes an optical unit (not shown). This optical unit has a plurality of lenses, and forms an image on a photoelectric conversion element (not shown) that receives light having passed through the optical unit and is accommodated in the housing 1104. The focal points of the plurality of lenses can be adjusted by adjusting the relative positions. This operation can also automatically be performed.

The light emitting device 10 may be applied to a display unit of an electronic apparatus. At this time, the display unit can have both a display function and an operation function. Examples of the portable terminal are a portable phone such as a smartphone, a tablet, and a head mounted display.

Fig. 14 is a schematic view showing an example of an electronic apparatus using the light emitting device 10 of this embodiment. An electronic apparatus 1200 includes a display unit 1201, an operation unit 1202, and a housing 1203. The housing 1203 can accommodate a circuit, a printed board having this circuit, a battery, and a communication unit. The operation unit 1202 can be a button or a touch-panel-type reaction unit. The operation unit 1202 can also be a biometric authentication unit that performs unlocking or the like by authenticating the fingerprint. The portable apparatus including the communication unit can also be regarded as a communication apparatus. The light emitting device 10 according to this

embodiment can be applied to the display unit 1201.

Figs. 15A and 15B are schematic views showing examples of the display device using the light emitting device 10 of this embodiment. Fig. 15A shows a display device such as a television monitor or a PC monitor. A display device 1300 includes a frame 1301 and a display unit 1302. The light emitting device 10 according to this embodiment can be applied to the display unit 1302. The display device 1300 can include a base 1303 that supports the frame 1301 and the display unit 1302. The base 1303 is not limited to the form shown in Fig. 15A. For example, the lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 15B is a schematic view showing another example of the display device using the light emitting device 10 of this embodiment. A display device 1310 shown in Fig. 15B can be folded, and is a so-called foldable display device. The display device 1310 includes a first display unit 1311, a second display unit 1312, a housing 1313, and a bending point 1314. The light emitting device 10 according to this embodiment can be applied to each of the first display unit 1311 and the second display unit 1312. The first display unit 1311 and the second display unit 1312 can also be one seamless display device. The first display unit 1311 and the second display unit 1312 can be divided by the bending point. The first display unit 1311 and the second display unit 1312 can display different images, and can also display one image together.

Fig. 16 is a schematic view showing an example of the illumination device using the light emitting device 10 of this embodiment. An illumination device 1400 can include a housing 1401, a light source 1402, a circuit board 1403, an optical film 1404, and a light diffusing unit 1405. The light emitting device 10 according to this embodiment can be applied to the light source 1402. The optical film 1404 can be a filter that improves the color rendering of the light source. When performing lighting-up or the like, the light diffusing unit 1405 can throw the light of the light source over a broad range by effectively diffusing the light. The illumination device can also include a cover on the outermost portion, as needed. The illumination device 1400 can include both or one of the optical film 1404 and the light diffusing unit 1405.

The illumination device 1400 is, for example, a device for illuminating the interior of the room. The illumination device 1400 can emit white light, natural white light, or light of any color from blue to red. The illumination device 1400 can also include a light control circuit for controlling these light components. The illumination device 1400 can also include a power supply circuit connected to the light emitting device 10 functioning as the light source 1402. The power supply circuit is a circuit for converting an AC voltage into a DC voltage. White has a color temperature of 4,200 K, and natural white has a color temperature of 5,000 K. The illumination device 1400 may also include a color filter. In addition, the illumination device 1400 can include a heat radiation unit. The heat radiation unit radiates the internal heat of the device to the outside of the device, and examples are a metal having a high specific heat and liquid silicon.

Fig. 17 is a schematic view of an automobile having a taillight as an example of a vehicle lighting appliance using the light emitting device 10 of this embodiment. An automobile 1500 has a taillight 1501, and can have a form in which the taillight 1501 is turned on when performing a braking operation or the like. The light emitting device 10 of this embodiment can be used as a headlight serving as a vehicle lighting appliance. The automobile is an example of a moving body, and the moving body may be a ship, a drone, an aircraft, a railroad car, an industrial robot, or the like. The moving body may include a main body and a lighting appliance provided in the main body. The lighting appliance may be used to make a notification of the current position of the main body.

The light emitting device 10 according to this embodiment can be applied to the taillight 1501. The taillight 1501 can include a protection member for protecting the light emitting device 10 functioning as the taillight 1501. The material of the protection member is not limited as long as the material is a transparent material with a strength that is high to some extent, and an example is polycarbonate. The protection member may be made of a material obtained by mixing a furandicarboxylic acid derivative, an acrylonitrile derivative, or the like in polycarbonate.

The automobile 1500 can include a vehicle body 1503, and a window 1502 attached to the vehicle body 1503. This window can be a window for checking the front and back of the automobile, and can also be a transparent display such as a head-up display. For this transparent display, the light emitting device 10 according to this embodiment may be used. In this case, the constituent materials of the electrodes and the like of the light emitting device 10 are formed by transparent members.

Further application examples of the light emitting device 10 according to this embodiment will be described with reference to Figs. 18A and 18B. The light emitting device 10 can be applied to a system that can be worn as a wearable device such as smartglasses, a Head Mounted Display (HMD), or a smart contact lens. An image capturing display device used for such application examples includes an image capturing device capable of photoelectrically converting visible light and a light emitting device capable of emitting visible light.

Glasses 1600 (smartglasses) according to one application example will be described with reference to Fig. 18A. An image capturing device 1602 such as a CMOS sensor or an SPAD is provided on the surface side of a lens 1601 of the glasses 1600. In addition, the light emitting device 10 according to this embodiment is provided on the back surface side of the lens 1601.

The glasses 1600 further include a control device 1603. The control device 1603 functions as a power supply that supplies electric power to the image capturing device 1602 and the light emitting device 10 according to each embodiment.

In addition, the control device 1603 controls the operations of the image capturing device 1602 and the light emitting device 10. An optical system configured to condense light to the image capturing device 1602 is formed on the lens 1601.

Glasses 1610 (smartglasses) according to one application example will be described with reference to Fig. 18B. The glasses 1610 include a control device 1612, and an image capturing device corresponding to the image capturing device 1602 and the light emitting device 10 are mounted on the control device 1612. The image capturing device in the control device 1612 and an optical system configured to project light emitted from the light emitting device 10 are formed in a lens 1611, and an image is projected to the lens 1611. The control device 1612 functions as a power supply that supplies electric power to the image capturing device and the light emitting device 10, and controls the operations of the image capturing device and the light emitting device 10. The control device 1612 may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The light emitting device 10 according to the embodiment of the present disclosure can include an image capturing device including a light receiving element, and control a displayed image based on the line-of-sight information of the user from the image capturing device.

More specifically, the light emitting device 10 decides a first visual field region at which the user is gazing and a second visual field region other than the first visual field region based on the line-of-sight information. The first visual field region and the second visual field region may be decided by the control device of the light emitting device 10, or those decided by an external control device may be received. In the display region of the light emitting device 10, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority is decided from the first display region and the second display region based on line-of-sight information. The first display region and the second display region may be decided by the control device of the light emitting device 10, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the light emitting device 10, the image capturing device, or an external device. If the external device holds the AI program, it is transmitted to the light emitting device 10 via communication.

When performing display control based on line-of-sight detection, smartglasses further including an image capturing device configured to capture the outside can be applied. The smartglasses can display captured outside information in real time.

## Claims

1. A light emitting device (10) comprising a substrate (8), a lens (17) with a refractive index n arranged on a main surface (34) of the substrate (8), and a light emitting region (32) arranged between the main surface (34) and the lens (17), wherein

   an upper surface of the lens (17) comprises a curved surface (40) that is convex in a direction away from the main surface (34),
   the curved surface (40) comprises a vertex (41) and an end portion (42) in a direction parallel to the main surface (34), and
   wherein

h [μm] represents a difference in height between the vertex (41) and the end portion (42) in a normal direction of the main surface (34), and r [μm] represents a distance between the vertex (41) and the end portion (42) in orthogonal projection to the main surface (34), and the expressions below are satisfied:

$$h < r \qquad (1)$$

$$\sin\theta = n \cdot \sin\alpha \qquad (2)$$

where θ represents an inclination angle between a tangent contacting the upper surface of the lens at the end portion of the curved surface and the direction parallel to the main surface, wherein θ is defined by $2rh/(r^2 + h^2) = \sin\theta$ wherein the curved
surface is a spherical surface, and where α represents an angle of a light ray that is generated in the light emitting region and refracted by the upper surface of the lens with the inclination angle θ such that it is extracted at the end portion of the lens into air in the normal direction of the main surface,
wherein
the following expressions are also satisfied:

$$\theta - \alpha = \beta \qquad (3);$$

$$a > r - H \cdot \tan\beta \qquad (4)$$

$$\gamma < 55° \qquad (5)$$

where H [μm] represents a difference in height between the end portion (42) and the light emitting region (32) in the normal direction, 2a [μm] represents a width of the light emitting region (32) in a direction parallel to the main surface (34), β represents an angle between said light ray and said normal direction (Fig. 1), and γ represents an angle that would be obtained if said lens were not present and said light ray were instead extracted into air at a position corresponding to the end portion of the curved surface from a medium having the refractive index n and a surface with θ = 0° at said position , so as to satisfy the following expression:

$$n \cdot \sin\beta = \sin\gamma \qquad (6).$$

2. The device according to claim 1, **characterized in that** the light emitting region comprises a light emitting layer containing a light emitting material, a first reflective layer arranged between the light emitting layer and the main surface, and a second reflective layer arranged between the light emitting layer and the lens.

3. The device according to claim 2, **characterized in that** at least one of the first reflective layer and the second reflective layer functions as an electrode.

4. The device according to claim 2 or 3, **characterized in that** an optical path length L [nm] between the first reflective layer and the second reflective layer satisfies

$$(2m - \Phi/\pi) \times (\lambda/4) \times (1/\cos\theta_{eml}) - \lambda/8 < L < (2m-\Phi/\pi) \times (\lambda/4) \times (1/\cos\theta_{eml}) + \lambda/8$$

where λ [nm] represents a peak wavelength of light that passes through the lens, m represents an integer not smaller than 0, Φ [rad] represents a sum of phase shifts when the light of the wavelength λ [nm] is reflected by the first reflective layer and the second reflective layer, and $\theta_{eml}$ [°] represents an angle that satisfies $0 < \sin\theta_{eml} < \sin\gamma/n_{eml}$ in a case where $n_{eml}$ represents a refractive index of the light emitting layer.

5. The device according to claim 2 or 3, **characterized in that** an optical path length L [nm] between the first reflective layer and the second reflective layer satisfies

$$(2m - \Phi/\pi) \times (\lambda/4) < L < (2m - \Phi/\pi) \times (\lambda/4) \times (1/\cos\theta_{eml}) + \lambda/8$$

where λ [nm] represents a peak wavelength of light that passes through the lens, m represents an integer not smaller

than 0, $\Phi$ [rad] represents a sum of phase shifts when the light of the wavelength $\lambda$ [nm] is reflected by the first reflective layer and the second reflective layer, and $\theta_{eml}$ [°] represents an angle that satisfies $0 < \sin\theta_{eml} < \sin\gamma/n_{eml}$ in a case where $n_{eml}$ represents a refractive index of the light emitting layer.

**6.** The device according to any one of claims 1 to 5, **characterized in that** $r - H\cdot\tan\beta > 0$ is further satisfied.

**7.** The device according to any one of claims 1 to 6, **characterized in that**

a medium layer with a refractive index $n_1$ is arranged between the light emitting region and the lens, and
a relationship of $n \leq n_1$ is satisfied.

**8.** The device according to claim 7, **characterized in that** the medium layer comprises a color filter.

**9.** The device according to claim 7 or 8, **characterized in that**

the medium layer is used as a first medium layer,
a second medium layer with a refractive index $n_2$ is arranged between the first medium layer and the light emitting region, and
a relationship of $n_1 \leq n_2$ is satisfied.

**10.** The device according to any one of claims 1 to 9, **characterized in that** a layer with a refractive index lower than n is not arranged between the light emitting region and the lens.

**11.** The device according to any one of claims 1 to 10, **characterized in that** a central portion of the light emitting region and a central portion of the lens are arranged to overlap each other in orthogonal projection to the main surface.

**12.** The device according to any one of claims 1 to 11, **characterized in that** $r > a$ is further satisfied.

**13.** A display device **characterized by** comprising the light emitting device according to any one of claims 1 to 12, and an active element connected to the light emitting device.

**14.** A photoelectric conversion device **characterized by** comprising an optical unit comprising a plurality of lenses, an image sensor configured to receive light having passed through the optical unit, and a display unit configured to display an image,
wherein the display unit displays an image captured by the image sensor, and comprises the light emitting device according to any one of claims 1 to 12.

**15.** An electronic apparatus **characterized by** comprising a housing provided with a display unit, and a communication unit provided in the housing and configured to perform external communication,
wherein the display unit comprises the light emitting device according to any one of claims 1 to 12.

## Patentansprüche

**1.** Lichtemittierende Einrichtung (10), die ein Substrat (8), eine Linse (17) mit einem Brechungsindex n, die auf einer Hauptfläche (34) des Substrats (8) angeordnet ist, und einen lichtemittierenden Bereich (32), der zwischen der Hauptfläche (34) und der Linse (17) angeordnet ist, umfasst, wobei

eine obere Fläche der Linse (17) eine gekrümmte Fläche (40) umfasst, die in einer Richtung weg von der Hauptfläche (34) konvex ist,
die gekrümmte Fläche (40) einen Scheitelpunkt (41) und einen Endabschnitt (42) in einer Richtung parallel zur Hauptfläche (34) umfasst, und
wobei h [$\mu$m] einen Höhenunterschied zwischen dem Scheitelpunkt (41) und dem Endabschnitt (42) in einer Normalenrichtung der Hauptfläche (34) darstellt und r [$\mu$m] einen Abstand zwischen dem Scheitelpunkt (41) und dem Endabschnitt (42) in orthogonaler Projektion auf die Hauptfläche (34) darstellt und die folgenden Ausdrücke erfüllt sind:

$$h < r \qquad (1)$$

$$\sin\theta = n \cdot \sin\alpha \qquad (2)$$

wobei $\theta$ einen Neigungswinkel zwischen einer Tangente, die die obere Fläche der Linse am Endabschnitt der gekrümmten Fläche berührt, und der Richtung parallel zur Hauptfläche darstellt, wobei $\theta$ durch $2rh/(r^2 + h^2) = \sin\theta$ definiert ist, wobei die gekrümmte Fläche eine sphärische Fläche ist, und wobei $\alpha$ einen Winkel eines Lichtstrahls darstellt, der im lichtemittierenden Bereich erzeugt und durch die obere Fläche der Linse mit dem Neigungswinkel $\theta$ so gebrochen wird, dass er am Endabschnitt der Linse in die Normalenrichtung der Hauptfläche in die Luft extrahiert wird,
wobei die folgenden Ausdrücke ebenfalls erfüllt sind:

$$\theta - \alpha = \beta \qquad (3);$$

$$a > r - H \cdot \tan\beta \qquad (4)$$

$$\gamma < 55° \qquad (5)$$

wobei H [$\mu$m] einen Höhenunterschied zwischen dem Endabschnitt (42) und dem lichtemittierenden Bereich (32) in der Normalenrichtung darstellt, 2a [$\mu$m] eine Breite des lichtemittierenden Bereichs (32) in einer Richtung parallel zur Hauptfläche (34) darstellt, $\beta$ einen Winkel zwischen dem Lichtstrahl und der Normalenrichtung darstellt (Fig. 1) und $\gamma$ einen Winkel darstellt, der erhalten würde, wenn die Linse nicht vorhanden wäre und der Lichtstrahl stattdessen an einer Position, die dem Endabschnitt der gekrümmten Fläche entspricht, aus einem Medium mit dem Brechungsindex n und einer Fläche mit $\theta = 0°$ an der Position in die Luft extrahiert würde, um den folgenden Ausdruck zu erfüllen:

$$n \cdot \sin\beta = \sin\gamma \qquad (6).$$

2. Einrichtung nach Anspruch 1, **dadurch gekennzeichnet, dass** der lichtemittierende Bereich eine lichtemittierende Schicht, die ein lichtemittierendes Material enthält, eine erste reflektierende Schicht, die zwischen der lichtemittierenden Schicht und der Hauptfläche angeordnet ist, und eine zweite reflektierende Schicht, die zwischen der lichtemittierenden Schicht und der Linse angeordnet ist, umfasst.

3. Einrichtung nach Anspruch 2, **dadurch gekennzeichnet, dass** mindestens eine der ersten reflektierenden Schicht und der zweiten reflektierenden Schicht als eine Elektrode fungiert.

4. Einrichtung nach Anspruch 2 oder 3, **dadurch gekennzeichnet, dass** eine optische Weglänge L [nm] zwischen der ersten reflektierenden Schicht und der zweiten reflektierenden Schicht

$$(2m - \Phi/\pi) \times (\lambda/4) \times (1/\cos\theta_{eml}) - \lambda/8 < L < (2m - \Phi/\pi) \times (\lambda/4) \times (1/\cos\theta_{eml}) + \lambda/8$$

erfüllt, wobei $\lambda$ [nm] eine Peakwellenlänge von Licht, das durch die Linse hindurchgeht, darstellt, m eine ganze Zahl nicht kleiner als 0 darstellt, $\Phi$ [rad] eine Summe von Phasenverschiebungen darstellt, wenn das Licht der Wellenlänge $\lambda$ [nm] durch die erste reflektierende Schicht und die zweite reflektierende Schicht reflektiert wird, und $\theta_{eml}$ [°] einen Winkel darstellt, der $0 < \sin\theta_{eml} < \sin\gamma/n_{eml}$ in einem Fall, in dem $n_{eml}$ einen Brechungsindex der lichtemittierenden Schicht darstellt, erfüllt.

5. Einrichtung nach Anspruch 2 oder 3, **dadurch gekennzeichnet, dass** eine optische Weglänge L [nm] zwischen der ersten reflektierenden Schicht und der zweiten reflektierenden Schicht

$$(2m - \Phi/\pi) \times (\lambda/4) < L < (2m - \Phi/\pi) \times (\lambda/4) \times (1/\cos\theta_{eml}) + \lambda/8$$

erfüllt, wobei $\lambda$ [nm] eine Peakwellenlänge von Licht, das durch die Linse hindurchgeht, darstellt, m eine ganze Zahl nicht kleiner als 0 darstellt, $\Phi$ [rad] eine Summe von Phasenverschiebungen darstellt, wenn das Licht der Wellenlänge

$\lambda$ [nm] durch die erste reflektierende Schicht und die zweite reflektierende Schicht reflektiert wird, und $\theta_{eml}$ [°] einen Winkel darstellt, der $0 < \sin\theta_{eml} < \sin\gamma/n_{eml}$ in einem Fall, in dem $n_{eml}$ einen Brechungsindex der lichtemittierenden Schicht darstellt, erfüllt.

6. Einrichtung nach einem der Ansprüche 1 bis 5, **dadurch gekennzeichnet, dass** ferner $r - H \cdot \tan\beta > 0$ erfüllt ist.

7. Einrichtung nach einem der Ansprüche 1 bis 6, **dadurch gekennzeichnet, dass**

   eine Mediumschicht mit einem Brechungsindex $n_1$ zwischen dem lichtemittierenden Bereich und der Linse angeordnet ist und
   eine Beziehung von $n \leq n_1$ erfüllt ist.

8. Einrichtung nach Anspruch 7, **dadurch gekennzeichnet, dass** die Mediumschicht einen Farbfilter umfasst.

9. Einrichtung nach Anspruch 7 oder 8, **dadurch gekennzeichnet, dass**

   die Mediumschicht als eine erste Mediumschicht verwendet wird,
   eine zweite Mediumschicht mit einem Brechungsindex $n_2$ zwischen der ersten Mediumschicht und dem lichtemittierenden Bereich angeordnet ist und
   eine Beziehung von $n_1 \leq n_2$ erfüllt ist.

10. Einrichtung nach einem der Ansprüche 1 bis 9, **dadurch gekennzeichnet, dass** eine Schicht mit einem Brechungsindex, der niedriger als n ist, nicht zwischen dem lichtemittierenden Bereich und der Linse angeordnet ist.

11. Einrichtung nach einem der Ansprüche 1 bis 10, **dadurch gekennzeichnet, dass** ein zentraler Abschnitt des lichtemittierenden Bereichs und ein zentraler Abschnitt der Linse so angeordnet sind, dass sie einander in orthogonaler Projektion auf die Hauptfläche überlappen.

12. Einrichtung nach einem der Ansprüche 1 bis 11, **dadurch gekennzeichnet, dass** ferner $r > a$ erfüllt ist.

13. Anzeigeeinrichtung, **dadurch gekennzeichnet, dass** sie die lichtemittierende Einrichtung nach einem der Ansprüche 1 bis 12 und ein aktives Element, das mit der lichtemittierenden Einrichtung verbunden ist, umfasst.

14. Einrichtung zur photoelektrischen Umwandlung, **dadurch gekennzeichnet, dass** sie eine optische Einheit, die mehrere Linsen umfasst, einen Bildsensor, der konfiguriert ist, Licht zu empfangen, das durch die optische Einheit gegangen ist, und eine Anzeigeeinheit, die konfiguriert ist, ein Bild anzuzeigen, umfasst,
    wobei die Anzeigeeinheit ein Bild anzeigt, das durch den Bildsensor erfasst wird, und die lichtemittierende Einrichtung nach einem der Ansprüche 1 bis 12 umfasst.

15. Elektronische Vorrichtung, **dadurch gekennzeichnet, dass** sie ein Gehäuse, das mit einer Anzeigeeinheit versehen ist, und eine Kommunikationseinheit, die in dem Gehäuse vorgesehen ist und konfiguriert ist, eine externe Kommunikation durchzuführen, umfasst,
    wobei die Anzeigeeinheit die lichtemittierende Einrichtung nach einem der Ansprüche 1 bis 12 umfasst.

## Revendications

1. Dispositif électroluminescent (10) comprenant un substrat (8), une lentille (17) avec un indice de réfraction n agencée sur une surface principale (34) du substrat (8), et une région électroluminescente (32) agencée entre la surface principale (34) et la lentille (17), dans lequel

   une surface supérieure de la lentille (17) comprend une surface incurvée (40) qui est convexe dans une direction s'éloignant de la surface principale (34),
   la surface incurvée (40) comprend un sommet (41) et une partie d'extrémité (42) dans une direction parallèle à la surface principale (34), et
   dans lequel h [$\mu$m] représente une différence de hauteur entre le sommet (41) et la partie d'extrémité (42) dans une direction normale de la surface principale (34), et r [$\mu$m] représente une distance entre le sommet (41) et la partie d'extrémité (42) en projection orthogonale sur la surface principale (34), et

les expressions ci-dessous sont satisfaites :

$$h < r \quad (1)$$

$$\sin\theta = n \cdot \sin\alpha \quad (2)$$

où $\theta$ représente un angle d'inclinaison entre une tangente entrant en contact avec la surface supérieure de la lentille au niveau de la partie d'extrémité de la surface incurvée et la direction parallèle à la surface principale, dans laquelle $\theta$ est défini par $2rh/(r^2 + h^2) = \sin\theta$, dans laquelle la surface incurvée est une surface sphérique, et où $\alpha$ représente un angle d'un rayon lumineux qui est généré dans la région électroluminescente et réfracté par la surface supérieure de la lentille avec l'angle d'inclinaison $\theta$ de telle sorte qu'il soit extrait au niveau de la partie d'extrémité de la lentille dans l'air dans la direction normale de la surface principale, dans lequel les expressions suivantes sont également satisfaites :

$$\theta - \alpha = \beta \quad (3) ;$$

$$a > r - H \cdot \tan\beta \quad (4)$$

$$\gamma < 55° \quad (5)$$

où H [$\mu$m] représente une différence de hauteur entre la partie d'extrémité (42) et la région électroluminescente (32) dans la direction normale, 2a [$\mu$m] représente une largeur de la région électroluminescente (32) dans une direction parallèle à la surface principale (34), $\beta$ représente un angle entre ledit rayon lumineux et ladite direction normale (Fig. 1), et $\gamma$ représente un angle qui serait obtenu si ladite lentille n'était pas présente et si ledit rayon lumineux était plutôt extrait dans l'air à une position correspondant à la partie d'extrémité de la surface incurvée d'un milieu ayant l'indice de réfraction n et une surface avec $\theta = 0°$ à ladite position, de façon à satisfaire à l'expression suivante :

$$n \cdot \sin\beta = \sin\gamma \quad (6).$$

2. Dispositif selon la revendication 1, **caractérisé en ce que** la région électroluminescente comprend une couche électroluminescente contenant un matériau électroluminescent, une première couche réfléchissante agencée entre la couche électroluminescente et la surface principale, et une seconde couche réfléchissante agencée entre la couche électroluminescente et la lentille.

3. Dispositif selon la revendication 2, **caractérisé en ce qu'**au moins une parmi la première couche réfléchissante et la seconde couche réfléchissante sert d'électrode.

4. Dispositif selon la revendication 2 ou 3, **caractérisé en ce qu'**une longueur de chemin optique L [nm] entre la première couche réfléchissante et la seconde couche réfléchissante satisfait à $(2m - \phi/\pi) \times (\lambda/4) \times (1/\cos\theta_{eml}) - \lambda/8 < L < (2m - \phi/\pi) \times (\lambda/4) \times (1/\cos\theta_{eml}) + \lambda/8$ où A [nm] représente une longueur d'onde de crête d'une lumière qui traverse la lentille, m représente un nombre entier non inférieur à 0, $\phi$ [rad] représente une somme de déphasages lorsque la lumière de la longueur d'onde $\lambda$ [nm] est réfléchie par la première couche réfléchissante et la seconde couche réfléchissante, et $\theta_{eml}$ [°] représente un angle qui satisfait à $0 < \sin\theta_{eml} < \sin\gamma/n_{eml}$ dans un cas où $n_{eml}$ représente un indice de réfraction de la couche électroluminescente.

5. Dispositif selon la revendication 2 ou 3, **caractérisé en ce qu'**une longueur de chemin optique L [nm] entre la première couche réfléchissante et la seconde couche réfléchissante satisfait à

$$(2m - \phi/\pi) \times (\lambda/4) < L < (2m - \phi/\pi) \times (\lambda/4) \times (1/\cos\theta_{eml}) + \lambda/8$$

où $\lambda$ [nm] représente une longueur d'onde de crête d'une lumière qui traverse la lentille, m représente un nombre entier non inférieur à 0, $\phi$ [rad] représente une somme de déphasages lorsque la lumière de la longueur d'onde $\lambda$ [nm] est réfléchie par la première couche réfléchissante et la seconde couche réfléchissante, et $\theta_{eml}$ [°] représente un angle qui satisfait à $0 < \sin\theta_{eml} < \sin\gamma/n_{eml}$ dans un cas où $n_{eml}$ représente un indice de réfraction de la couche

électroluminescente.

**6.** Dispositif selon l'une quelconque des revendications 1 à 5, **caractérisé en ce que** $r - H \cdot \tan\beta > 0$ est en outre satisfaite.

**7.** Dispositif selon l'une quelconque des revendications 1 à 6, **caractérisé en ce que**

une couche intermédiaire avec un indice de réfraction $n_1$ est agencée entre la région électroluminescente et la lentille, et
une relation $n \leq n_1$ est satisfaite.

**8.** Dispositif selon la revendication 7, **caractérisé en ce que** la couche intermédiaire comprend un filtre coloré.

**9.** Dispositif selon la revendication 7 ou 8, **caractérisé en ce que**

la couche intermédiaire est utilisée comme première couche intermédiaire,
une seconde couche intermédiaire avec un indice de réfraction $n_2$ est agencée entre la première couche intermédiaire et la région électroluminescente, et
une relation $n_1 \leq n_2$ est satisfaite.

**10.** Dispositif selon l'une quelconque des revendications 1 à 9, **caractérisé en ce qu'**une couche avec un indice de réfraction inférieur à n n'est pas agencée entre la région électroluminescente et la lentille.

**11.** Dispositif selon l'une quelconque des revendications 1 à 10, **caractérisé en ce qu'**une partie centrale de la région électroluminescente et une partie centrale de la lentille sont agencées pour se chevaucher l'une l'autre en projection orthogonale sur la surface principale.

**12.** Dispositif selon l'une quelconque des revendications 1 à 11, **caractérisé en ce que** $r > a$ est en outre satisfaite.

**13.** Dispositif d'affichage **caractérisé en ce qu'**il comprend le dispositif électroluminescent selon l'une quelconque des revendications 1 à 12, et un élément actif connecté au dispositif électroluminescent.

**14.** Dispositif de conversion photoélectrique **caractérisé en ce qu'**il comprend une unité optique comprenant une pluralité de lentilles, un capteur d'image configuré pour recevoir une lumière ayant traversé l'unité optique, et une unité d'affichage configurée pour afficher une image, dans lequel l'unité d'affichage affiche une image capturée par le capteur d'image, et comprend le dispositif électroluminescent selon l'une quelconque des revendications 1 à 12.

**15.** Appareil électronique **caractérisé en ce qu'**il comprend un boîtier pourvu d'une unité d'affichage, et une unité de communication fournie dans le boîtier et configurée pour réaliser une communication externe,
dans lequel l'unité d'affichage comprend le dispositif électroluminescent selon l'une quelconque des revendications 1 à 12.

FIG. 1

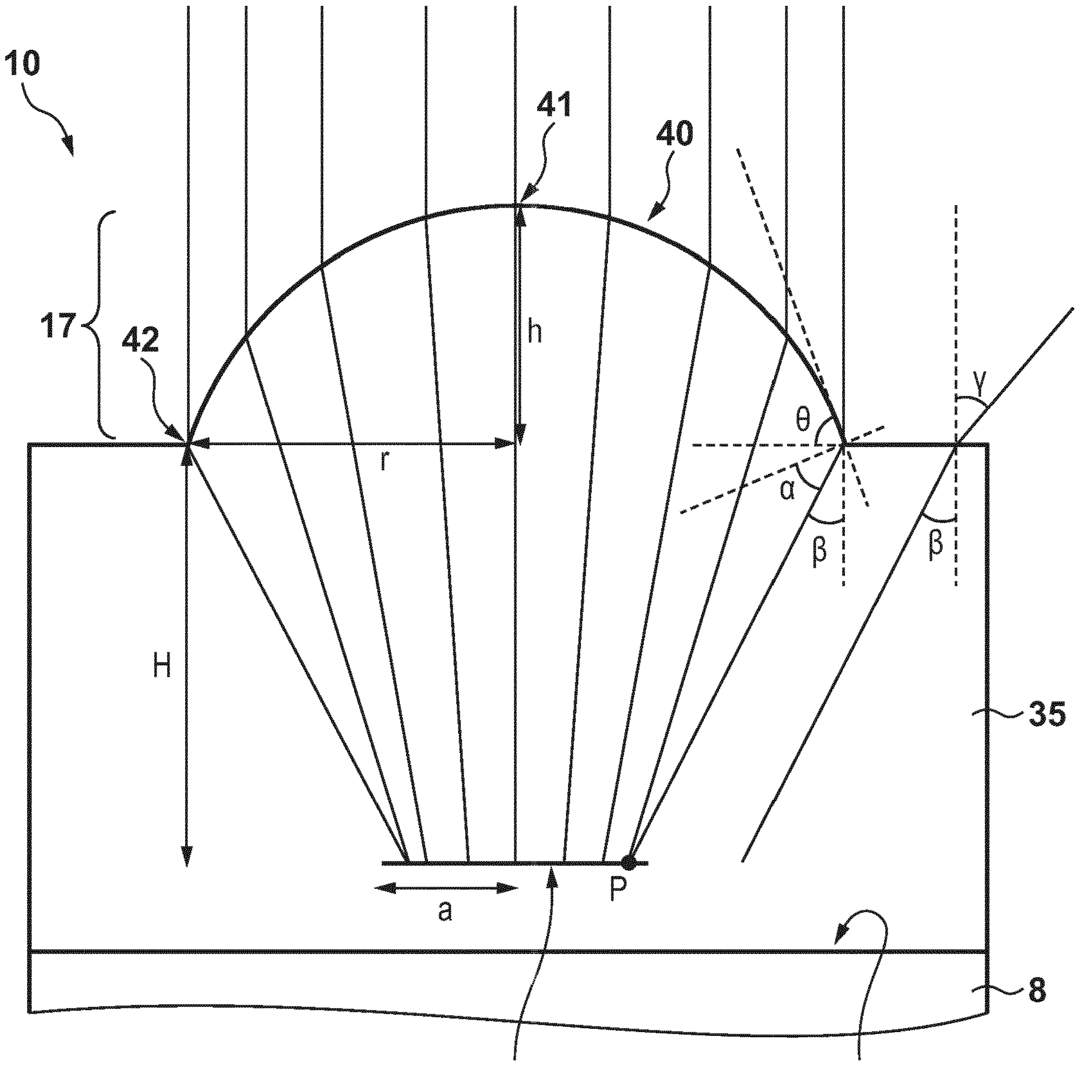

# FIG. 2

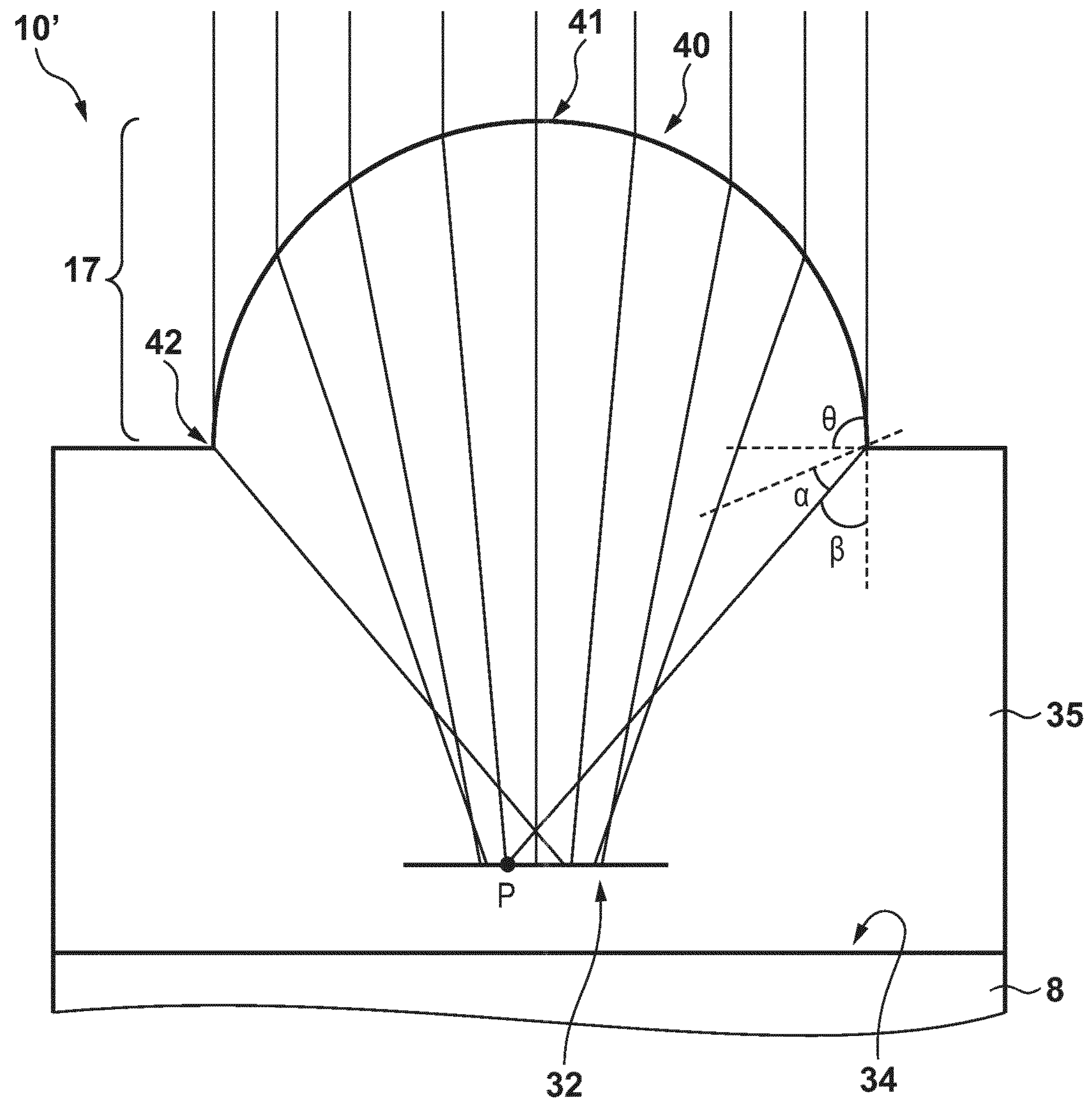

# F I G. 3

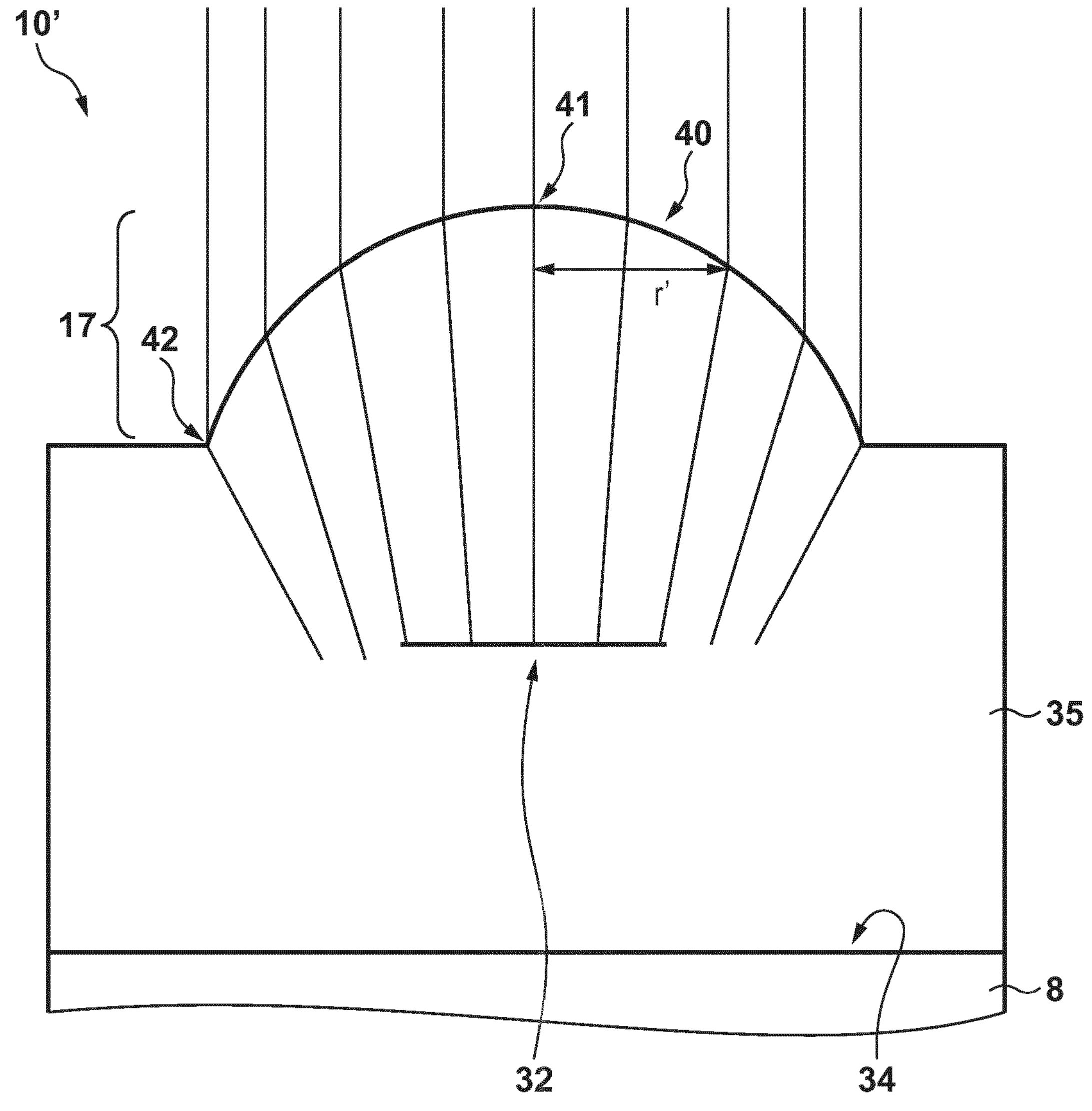

FIG. 4

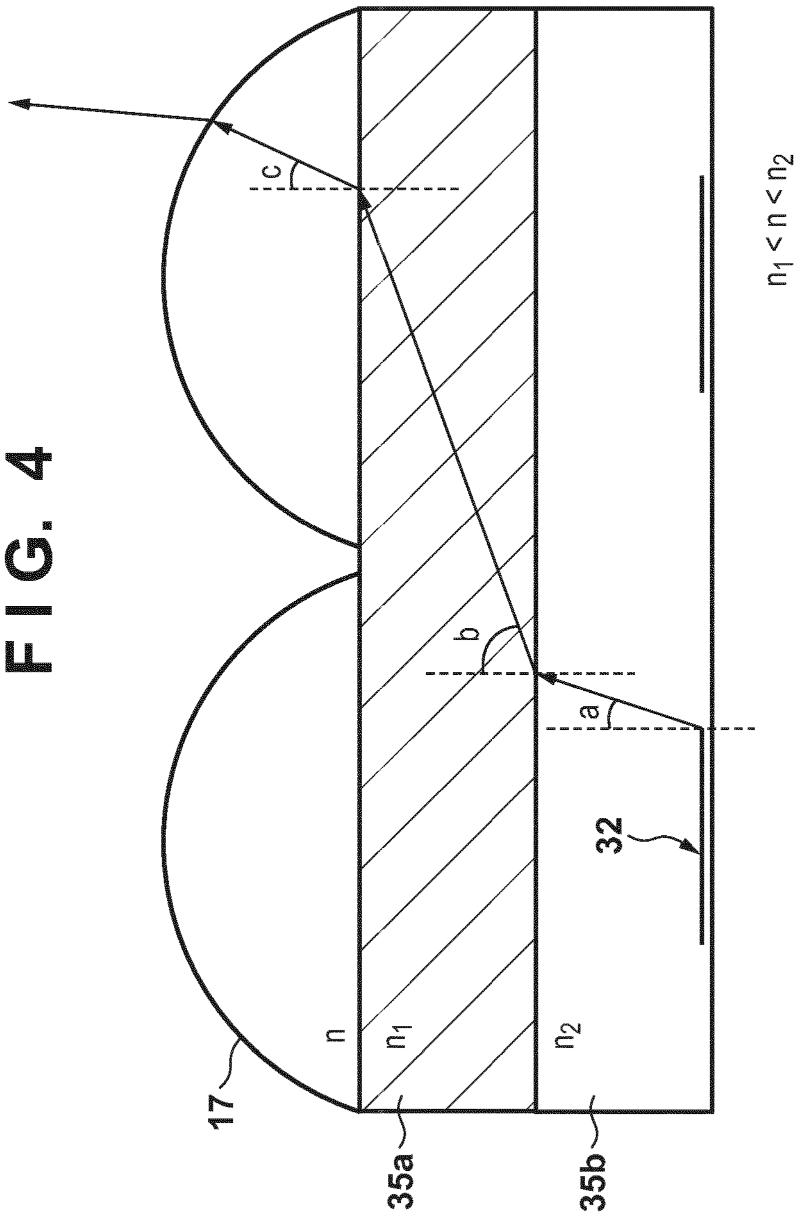

FIG. 5

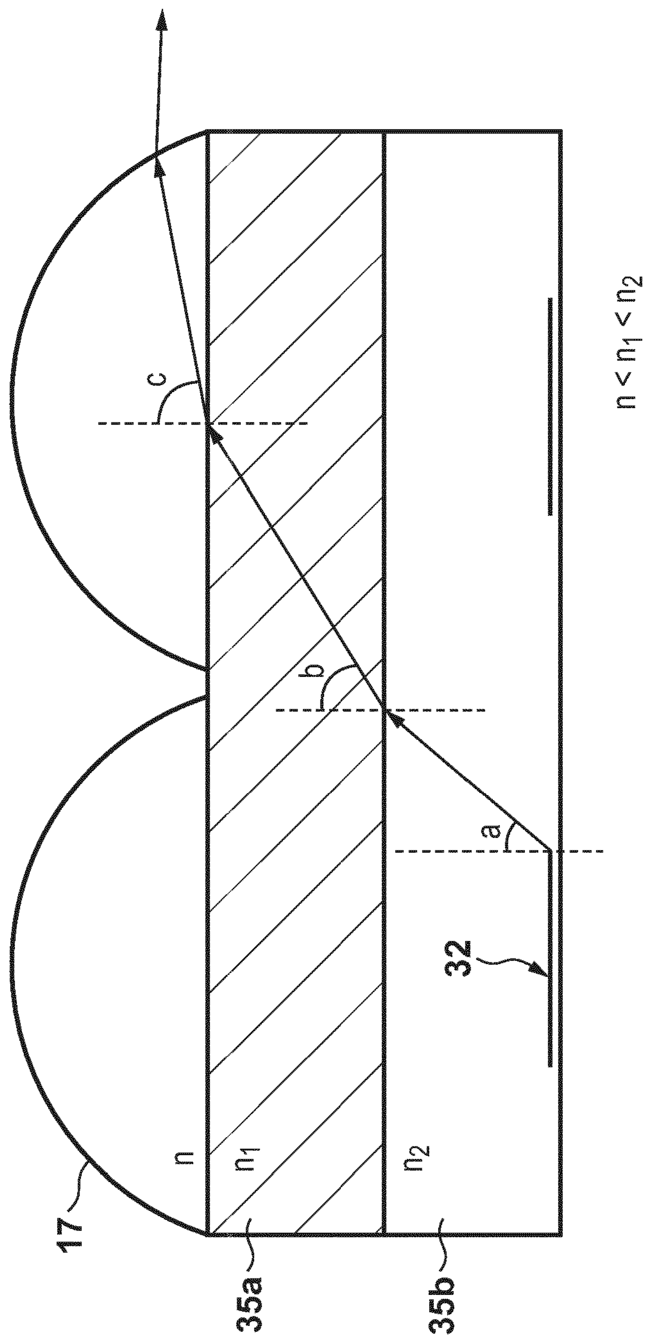

FIG. 6

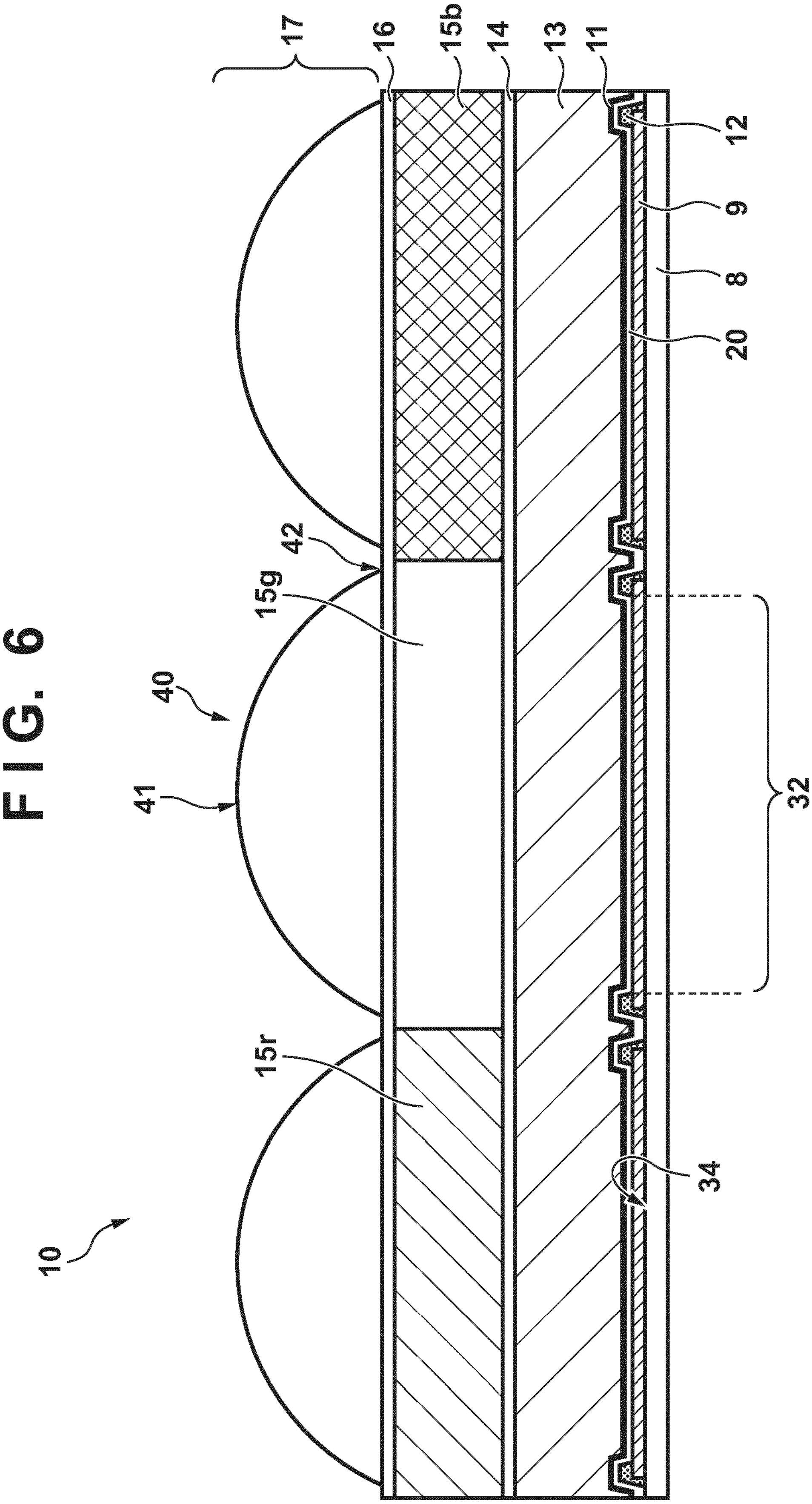

FIG. 7A

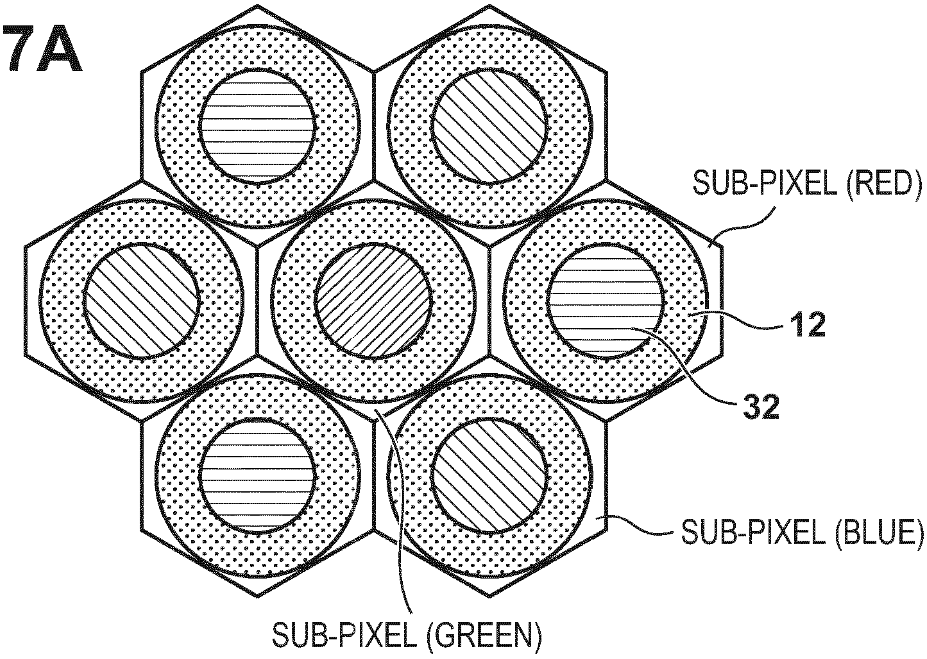


FIG. 7B

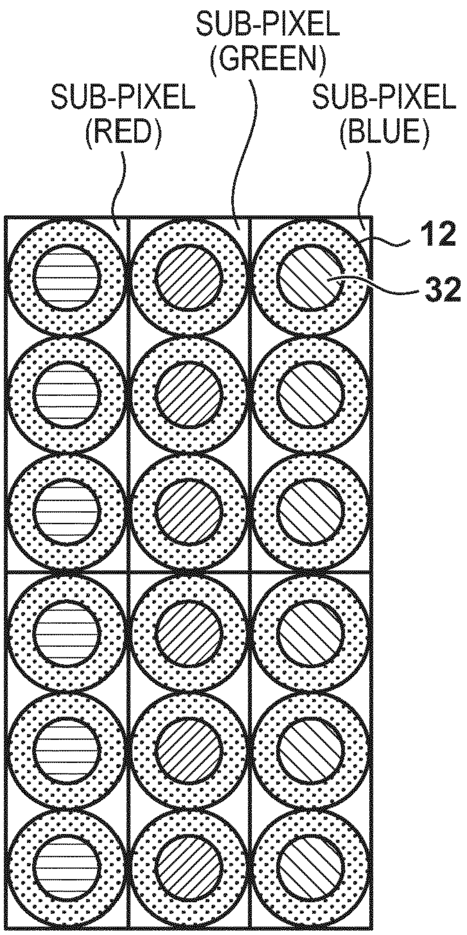


FIG. 7C

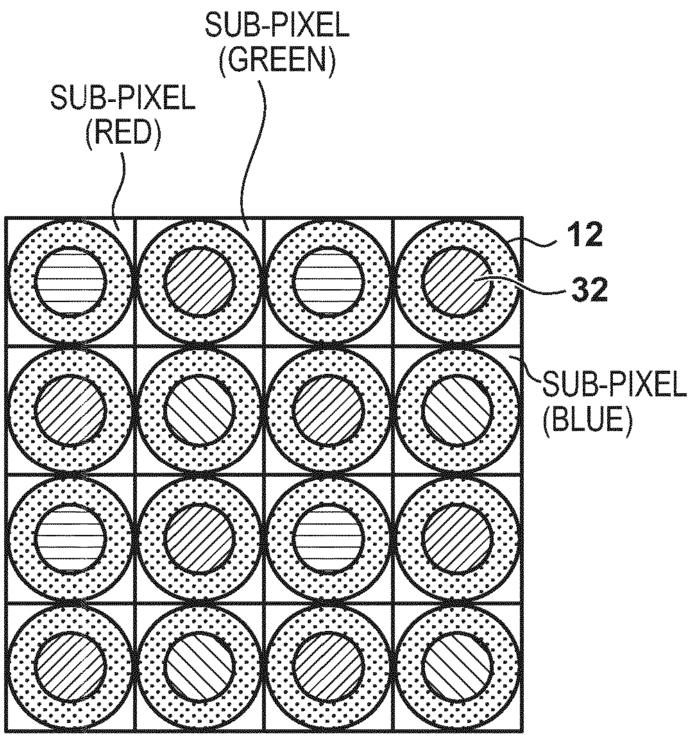

FIG. 8

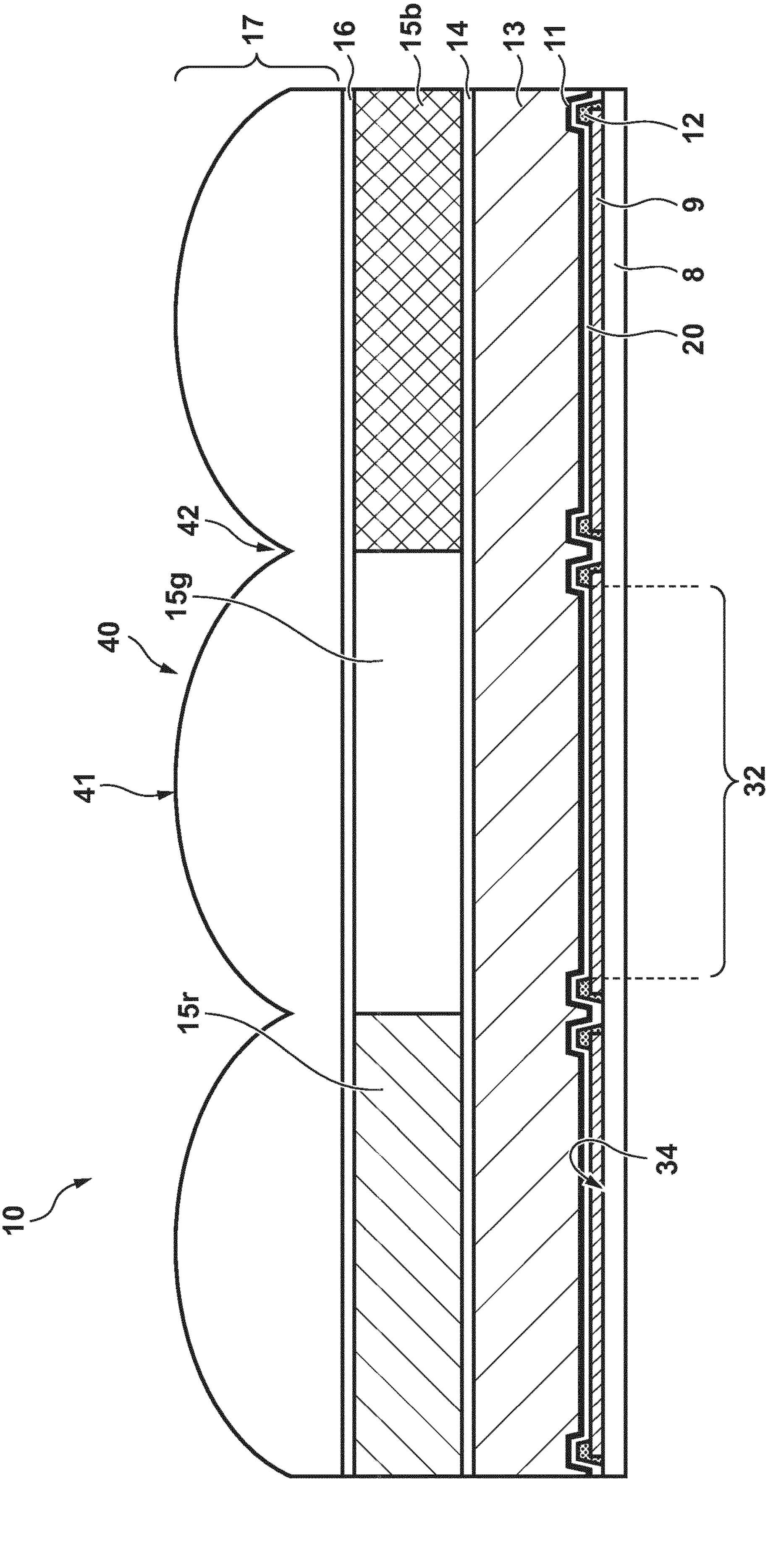

FIG. 9

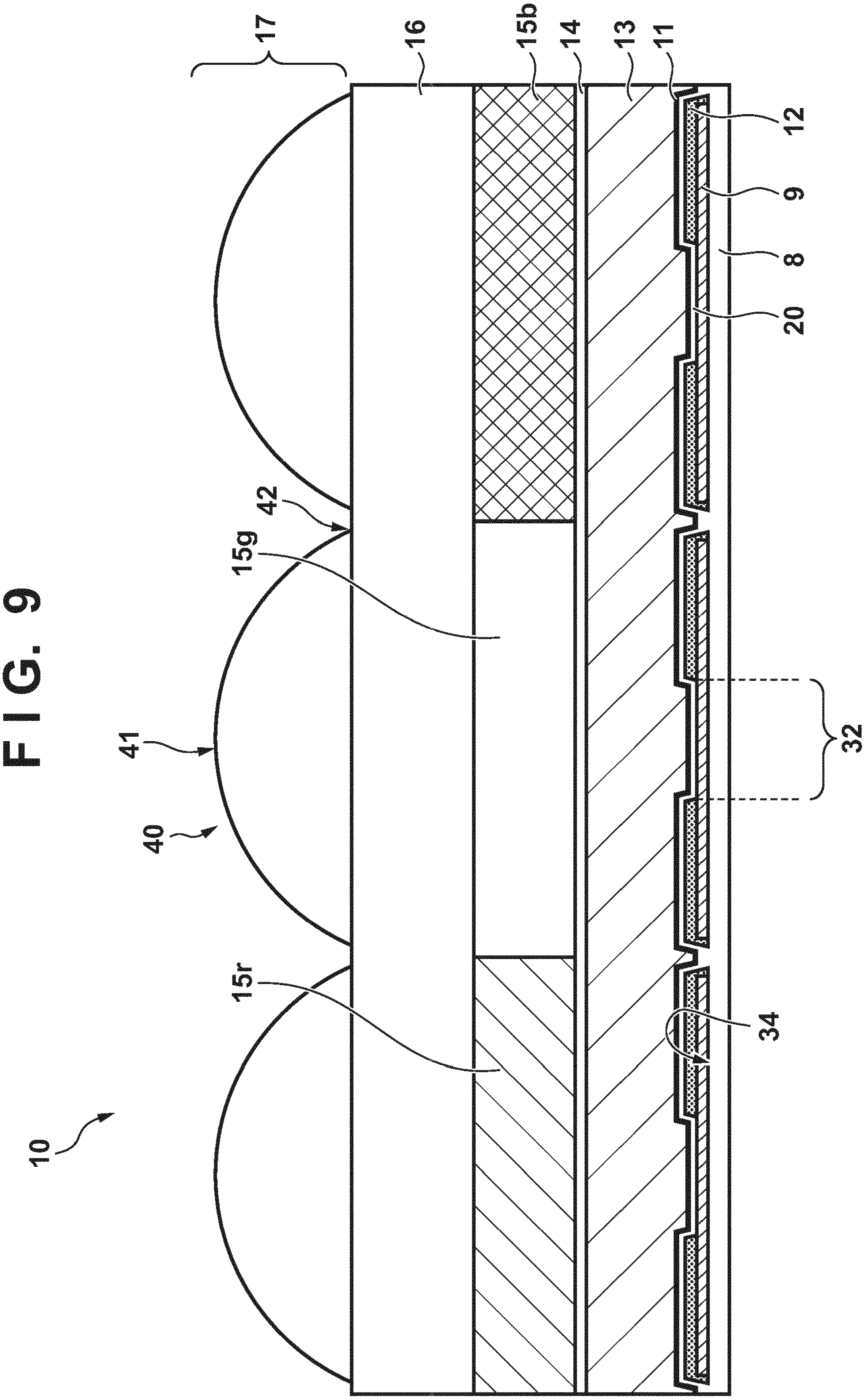

FIG. 10

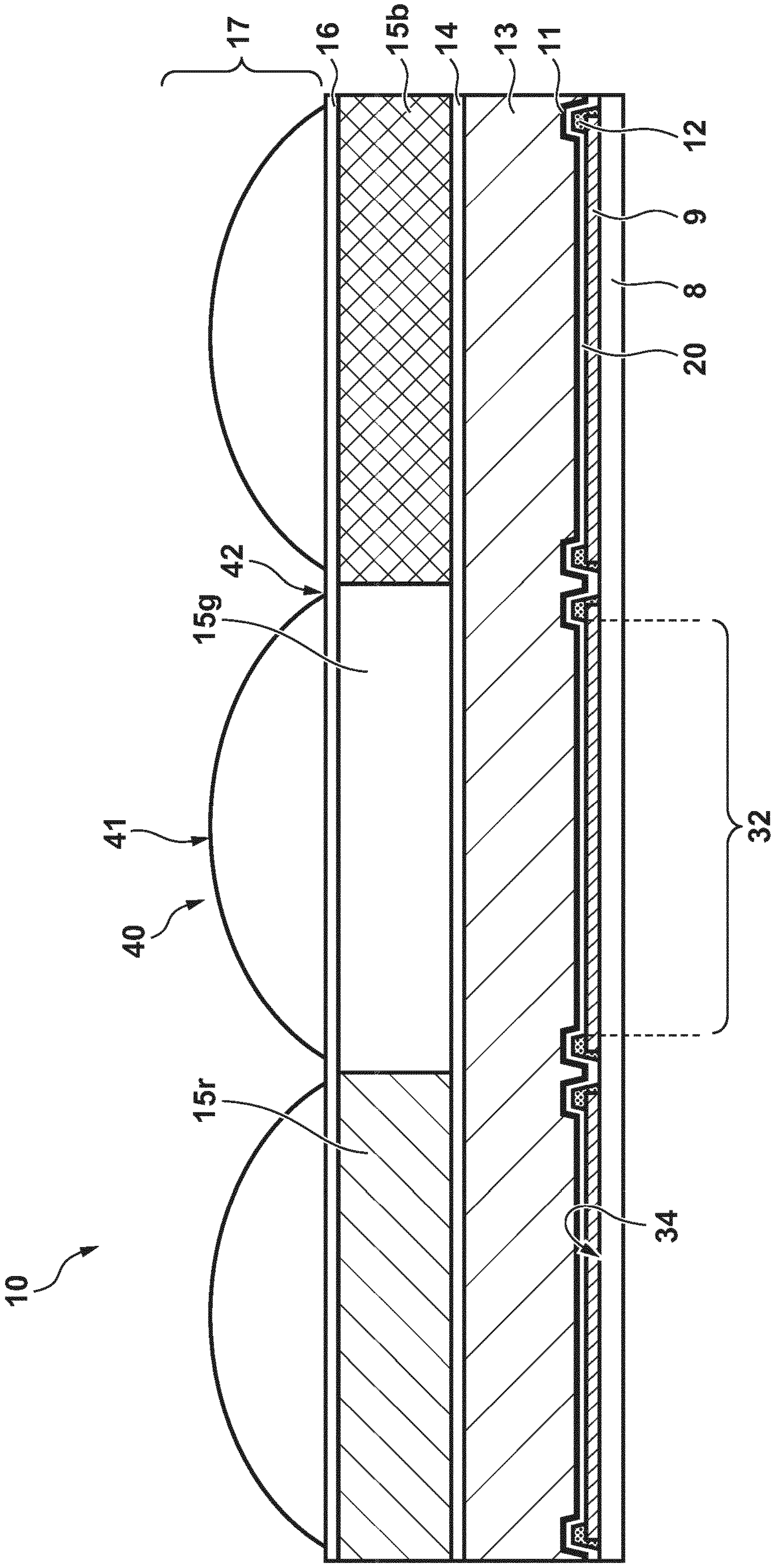

FIG. 11

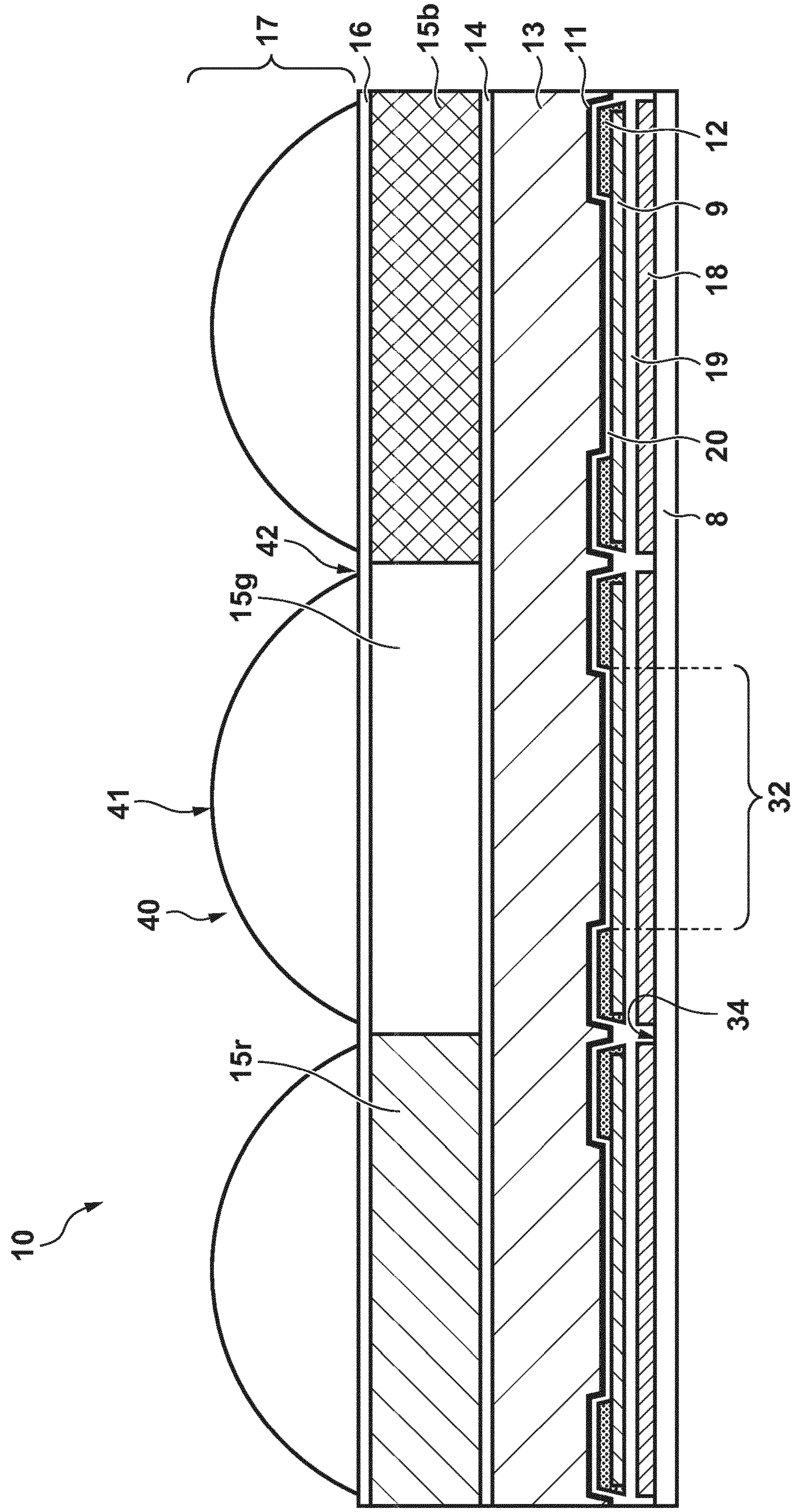

FIG. 12

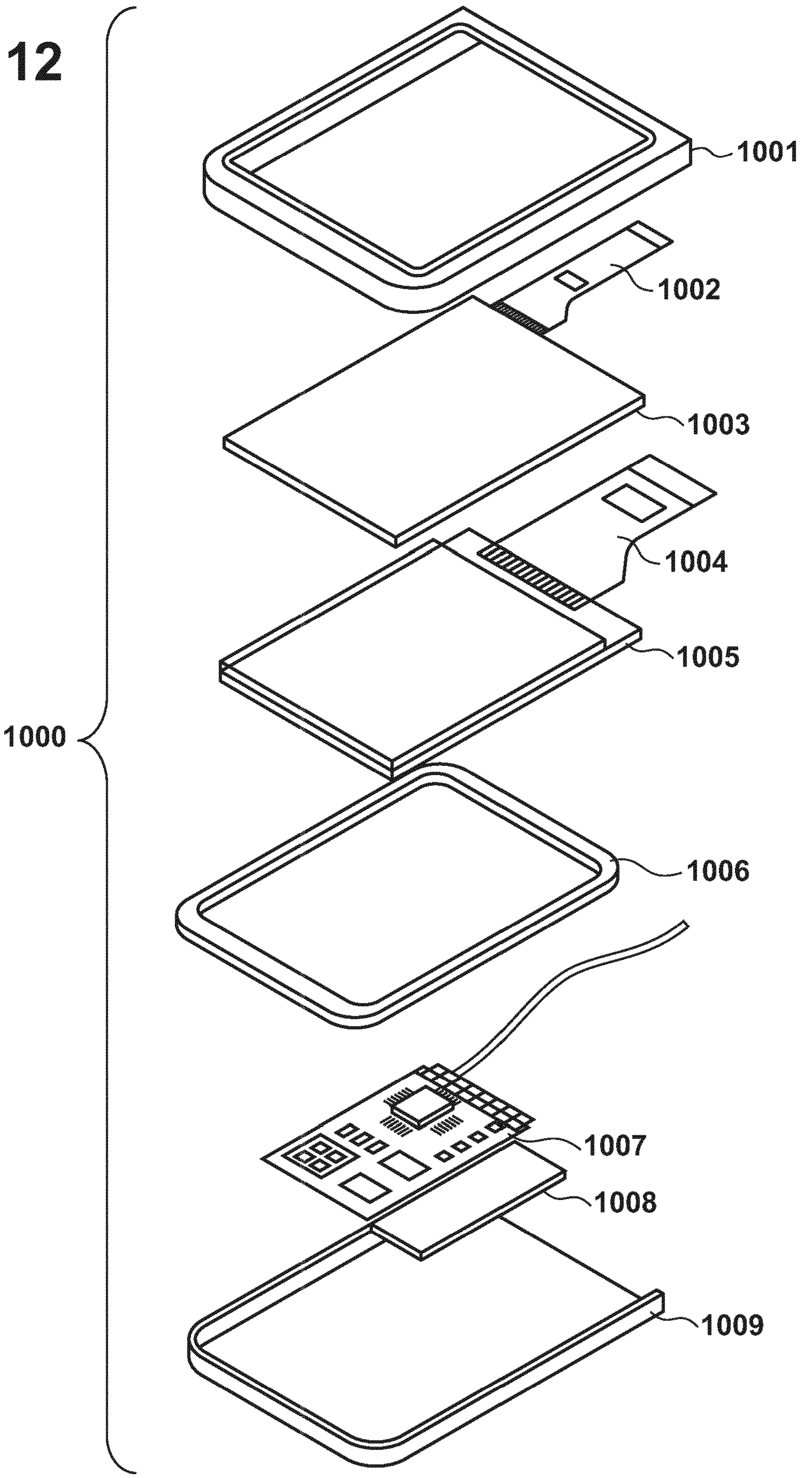

# FIG. 13

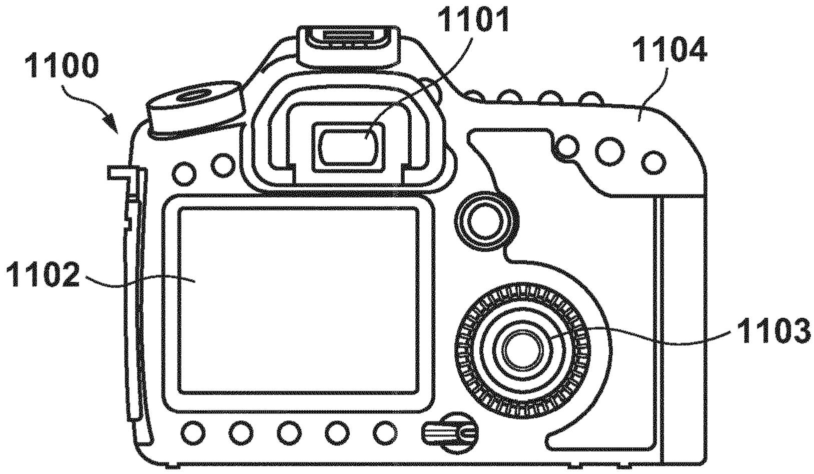


# FIG. 14

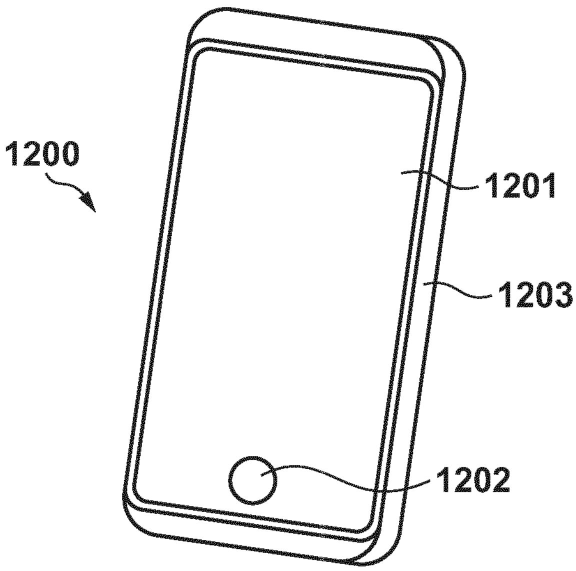

FIG. 15A

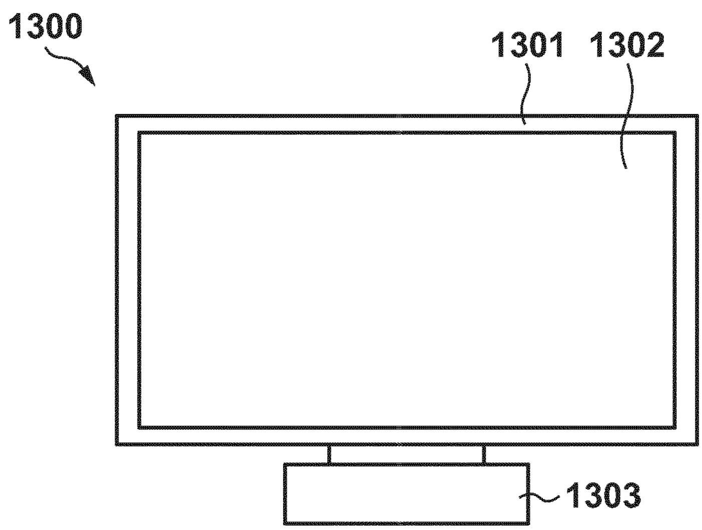


FIG. 15B

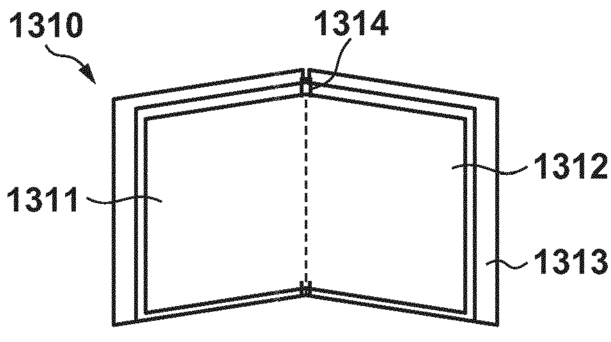

FIG. 16

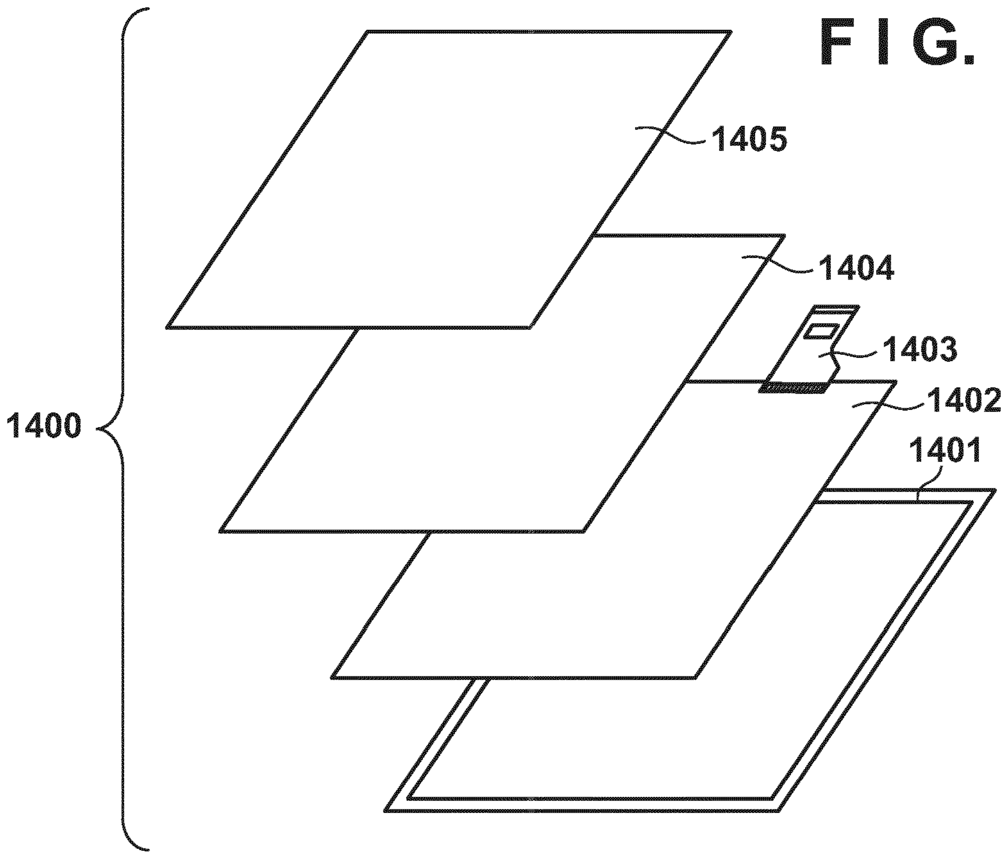


FIG. 17

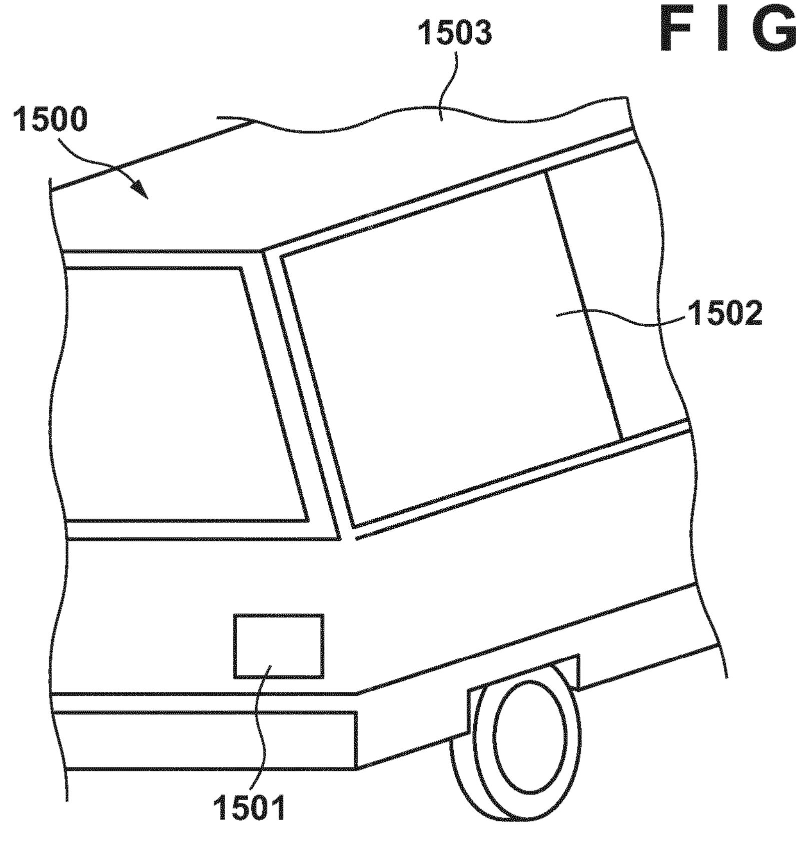

FIG. 18A

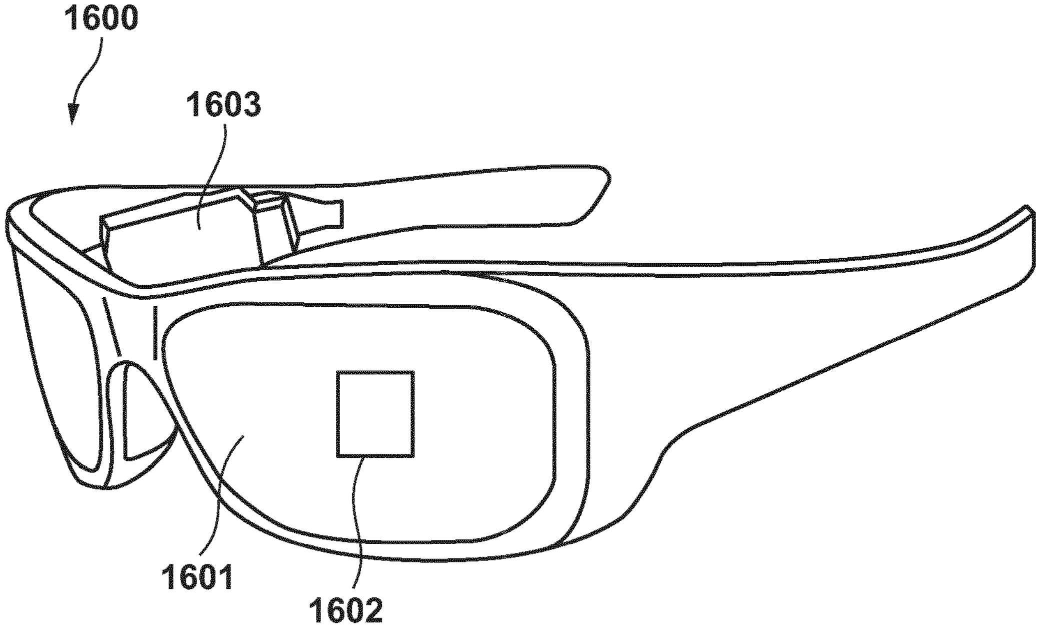


FIG. 18B

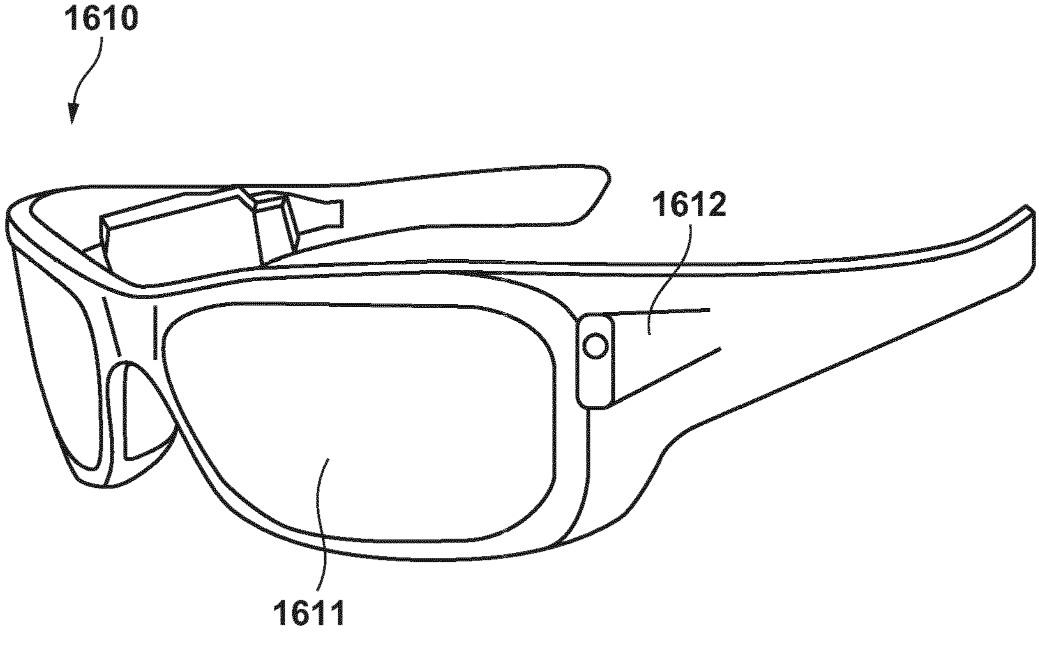

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017017013 A
- EP 3993081 A1